# EUROPEAN PATENT APPLICATION

(11) **EP 4 518 583 A1**
(43) Date of publication of application: **05.03.2025**
(21) Application number: 24222519.1
(22) Date of filing: 18.06.2018
(51) Int. Cl.: H05B 47/19, G05B 13/02, G05B 19/02, G01R 21/06

(54) **INTELLIGENT SWITCH DEVICE AND CENTRAL CONTROL SYSTEM THEREOF**

(30) Priority: 01.08.2017 US 201715665894; 07.06.2018 US 201816002177; 07.06.2018 US 201816002228; 07.06.2018 US 201816002187
(62) Divisional of application: 18841037.7
(71) Applicant: Kleverness Incorporated, Walnut, CA 91789 (US)
(72) Inventor: ELLIOT, Dan, Nurko, 53950 Naucalpan de Juarez (MX); LEYVA ROS, Marco, Polo, 03100 Ciudad de Mexico (MX); ABUNDIS, Hector, Munguia, 54090 Tlainepantla (MX); CASTILLO BARCENAS, Fidel, Nahum, 56650 Temamatla (MX); FLORES, Nelly, Adriana Estrada, 01780 Alvaro Obergon (MX); GARCIA, Josue, Saul Rosario, 56560 Ixtapaluca (MX); PUC POOT, Francisco, Antonio, 06920 Delegacion Cuauhtemoc (MX); ZENTENO, Leobardo, Stephen Lincoln Strange, 07870 Delegacion (MX); SOTO, Gerardo, Gomez, 56020 Tequisistlan Tezoyuca (MX); RIOS, Edmundo, Leyva, 09800 Iztapalapa (MX); RAMIREZ, Carlos, Mucino, 01180 Alvaro Obergon (MX); YOMTOW, Samuel, Nurko, Huixquilucan (MX)
(74) Representative: Clarke, Modet y Cía., S.L.

(57) **Abstract**

A system comprises a power supply (101a), in which, a first low power module (106) receives AC power from mains electricity (111) flowing through a lighting load (112a) and a low power lighting load adapter (113) when the lighting load (112a) is off, converts AC power into a first level DC voltage and outputs the first level DC voltage to a second low power module (107) that converts the first level DC voltage into a second level DC voltage when the lighting load (112a) is off, wherein the second low power module (107) converts the first level DC voltage from a third low power module (108) into the second level DC voltage when the lighting load (112a) is on. The third low power module (108) receives a shunt current (116) and outputs the first level DC voltage to the second low power module (107) when the lighting load (112a) is on. A high power module (109) turns on the lighting load (112a) based on an activation signal.

## Description

### TECHNICAL FIELD OF THE INVENTION

The present invention relates to the technical field of automatic control of lighting devices, as well as the remote control, via mobile devices, of lighting devices preferably for domestic use.

### BACKGROUND OF THE INVENTION

In recent years, there has been a development in technology that has been applied in the automation of houses, buildings, etc., which has been termed as home automation or domotics.

A key part of home automation is the automation of lighting systems, which has involved considerable development in the industry that manufactures intelligent devices to control lighting devices such as intelligent switch devices.

The quick development of areas such as computer science, electronics, and information and communication technologies has allowed great advances that have been applied in home automation, and specifically, to the control of lighting systems, developing new concepts in technology such as building automation, which has been developed to provide better comfort and service to large facilities.

On the other hand, the trend to develop products that allow the user to control the different installations of a house or building, through remote user equipment such as mobile devices and wearable devices, as well as through the internet; has allowed the user to have a more dynamic and comfortable panorama of its surroundings.

Smart switches usually need three wires to function, that is, a hot wire from the alternating-current (AC) source is connected to one terminal of the smart switch, a second wire is connected to another terminal of the smart switch and the lighting device, and a neutral wire from the AC source is connected to a third terminal of the smart switch, which closes the circuit inside the smart switch, allowing current flow for the operation of the electronics of the smart switch.

Usually, the electrical wiring of homes has only the first two wires in a switch box or wall box, with the neutral wire absent from the switch box, since common (non-smart) switches or dimmers are connected in series between the AC source and the lighting device. This yields the problem of having to rewire the entire home in order to bring a neutral wire from the AC source to the switch box.

Some smart switches are only able to measure one or two parameters of the lighting devices they control. Within these parameters it has been found that the most predominant is the measurement of electrical/power consumption. Said power consumption is calculated for an entire circuit (one way, line, or gang), i.e. for all the electric loads combined connected to the circuit. Therefore, a user cannot measure the power consumption of each individual load. The power consumed by each individual load is useful to know if a lighting device is consuming more power than usual or to know when to replace a lighting device. The method used to determine the electrical consumption is based on sampling the current consumption of the lighting device during a time interval of operation, said sampling being processed by a microcontroller to determine the electrical/power consumption. There are also two- or three-wire smart switches that can dim different lighting technologies (LED, CFL and incandescent bulb), wherein the lighting intensity dimming is carried out through methods known as leading or trailing edge.

A power source for a two-wire smart switch is disclosed in U.S. patent applications Ser. No. 12/952,920 and 15/131,444 and their families. However, said implementations need an adapter or artificial load for each circuit to be controlled by the switch, i.e. one adapter for each switch in a gang switch. The dimmer switch implements a TRIAC, but may alternatively implement one or more silicon-controlled rectifiers (SCRs), or any suitable thyristor. The TRIAC comprises two main terminals that are coupled in series electrical connection between the hot terminal H and the dimmed hot terminal DH, such that the TRIAC is adapted to be coupled in series electrical connection between the AC power source and a LED driver for conducting the load current to the LED driver. The load control device has a mechanical switch that controls the powering of the whole device, and when the mechanical switch is off, the system is unpowered, therefore requiring the physical input from a user to reactivate the load control device. Therefore, the dimmer cannot allow the remote operation of the same if the switch is off, which limits its smart capabilities.

Another two-wire power supply for a smart switch is described in US 8,892,913 B2. However, the power delivered by said power supply is very low, since it is provided by a capacitor that gets charged near the zero-crossing of the AC wave. If the capacitor is not fully charged, the power supply may turn off some of its elements, like an LED or a communications module. Another disadvantage of US '913 B2 is that the circuit is fairly complex, requiring a microprocessor to control the power supply. The microprocessor is powered by the power supply, therefore, if any of the two were to fail, the other would fail too.

A device for power measurement is disclosed in U.S. patent application 14/991,133, however, said device does not measure the power consumption of an individual technology type load, but the combined loads in a circuit.

The power measurement in a two-wire load control device described in US 9, 250, 669 B2 discloses a current measuring circuit that includes only a resistor (e.g., a micro-Ohm resistor) that may be used to measure a current to be inputted in ADC, that passes through the two-wire load control device. Wherein the control circuit is electrically connected between the controller and a controllably conductive device (a bidirectional semiconductor). However, the two-wire load control device can only operate one conductive device, therefore, control only a single lighting load at the same time. Additionally, the two-wire load control device relies on an energy storage device (a capacitor), therefore the power is not supplied continuously.

Another dimmer switch for use with lighting circuits having three-wire switches is described in US 7,687,940 B2. However, the smart switch can be installed only in three or four-way switches systems, wherein the lighting control system has implemented a sensing circuit that has a current sense transformer that only operates above a minimum operating frequency, for example, 100 kHz, such that current only flows in the secondary winding when the current waveform through the primary winding has a frequency above the minimum operating frequency, wherein the system includes only two controllably conductive devices or bidirectional semiconductor switches, such as a TRIACs. A controller is coupled to the gate of the TRIAC through a gate drive circuit and controls the conduction time of the TRIAC each half-cycle. A power supply is coupled across the TRIAC and generates a DC voltage VCC to power the controller. A zero-crossing detector determines the zero-crossing points of the AC voltage source and provides this information to the controller. An airgap switch disconnects the dimmer switch and the lighting load from the AC voltage source and therefore de-energizes the controller. A memory is required for storing the present state of the dimmer switch, wherein the lighting control system has implemented a sensing circuit that has a current sense transformer that only operates above a minimum operating frequency, for example, 100 kHz, such that current only flows in the secondary winding when the current waveform through the primary winding has a frequency above the minimum operating frequency, wherein the system includes only two controllably conductive devices or bidirectional semiconductor switches, such as a TRIACs. However, the power supply of the system sometimes is unable to supply power to the controller through the duration of a toggle or switching of the three-way switch, and the controller of the system will reset. Therefore, the reliability of the dimmer is belittled, since a voltage variation will cause a malfunctioning if the power supply does not draw enough energy to keep itself functioning. Additionally, if the state of the power supply or dimmer is not stored in the memory, the power supply will not operate correctly.

A load control device for high-efficiency loads is disclosed in U.S. Patents US 9,343,997 B2, US 9,343,998 and US 9,853,561 B2. The control device comprises only one bidirectional semiconductor switch that comprises a control input (e.g., a gate), which may receive control signals for rendering the bidirectional semiconductor switch conductive and non-conductive. However, the load control device has a mechanical switch that controls the powering of the whole device, and when the mechanical switch is off, the system is unpowered, therefore requiring the physical input from a user to reactivate the load control device. Additionally, the load control device it is limited to control only one lighting load at a time.

A smart electronic switch for low-power loads is disclosed in U.S. Patents US 8,922,133 B2 and US 9,418,809 B2, wherein the electronic switch comprises two power supplies: an on-state power supply and an off-state power supply. Both power supplies, operate to generate a DC supply voltage across an output capacitor. Wherein the electronic switch has implemented a bidirectional semiconductor switch that is coupled in series electrical connection with the parallel combination of a relay and an on-state power supply. The on-state power supply operates to generate the DC supply voltage when the relay is closed and the lighting load is on. However, this system is not compatible with a three-wire switch box. Additionally, the two-wire load control device relies on an energy storage device (a capacitor), and a relay, which are prone to failure.

A method for power Measurement in a Two-Wire Load Control Device is disclosed in US 9,250,669 B2. More specifically, it is disclosed a load control device for two or three wire switches, that includes a microcontroller and integrated circuits. Wherein the controller detects via a zero-cross detection circuit a zero crossing event. The controller is configured to issue a control signal to a drive circuit to operate the controllably conductive device at a firing time during a half-cycle. The controllably conductive device is implemented as a TRIAC, the TRIAC will become non-conductive when the load current through the TRIAC drops below a rated holding current of the TRIAC at the end of the half-cycle, however, said device relies on an energy storage device (a capacitor), therefore the power is not supplied continuously. Furthermore, the load control device describes a forward phase control and is silent on how to perform reverse phase control, which is more complex and usually requires more electronic components than forward phase control.

A smart dimming solution for LED light bulb and other non-linear power AC loads in US 9,354,643 B2 discloses a dimmer that employs a TRIAC and two IGBTs. The dimmer is capable of switching between at least three distinct modes of operation. In this first mode the current flows solely through TRIAC in both the positive and negative cycles of VAC, while IGBTs remain deactivated. A second mode the current flows solely through one of the IGBTs, depending on the cycle of VAC, while TRIAC remains deactivated. In the third or intermediate mode, TRIAC, both IGBTs are selectively activated and can selectively operate in a forward or reverse phase control embodiment. In this third mode, the majority of current flows to the load through activated TRIAC, but TRIAC can be deactivated before a zero volt crossing by VAC during either the positive or negative cycle. In this mode, TRIAC is deactivated when one of the IGBTs is activated for a very short period of time. An activated IGBT, in essence electrically shorts the TRIAC, which in turn starves TRIAC of the minimal holding current needed to maintain conduction. However, the use of three semiconductor devices complicates the operation and manufacturing, diminishes the reliability due a to a higher number of components for controlling only one lighting load and passively consumes more energy while dimming.

United States Patent US 9 250 669 B2 discloses an energy measurement chip included in a device for controlling lighting devices. A voltage signal in the lighting device is provided for the energy measurement chip, said energy measurement chip calculates the energy consumed by the lighting device and communicates said calculation to a controller external to the energy measurement chip. However, said US patent does not disclose a data filtering to eliminate the noise present in the voltage signal, wherein said filtering is comprised by an amplitude filtering, a frequency filtering and a magnitude filtering. Data filtering allows ignoring variations or small voltage peaks that affect the treatment and evaluation of the voltage signal analyzed. Another great difference found is that the US patent does not disclose or suggest a method of detecting type of lighting device technology, that is, said US patent can not determine if the lighting device is an incandescent halogen device (incandescent bulb) or a compact fluorescent device (CFL) or a light-emitting diode (LED) device. Also, said US patent fails to disclose or suggest a method of detecting irregular behavior in the operation of a lighting device, i.e., said US patent can not determine if an intelligent device is consuming more current than it should and probably the lighting device is in a state of deterioration. As a last difference, said US patent does not mention anything regarding a method of detection and selection of a dimming mode, that is, said US patent can not detect the most appropriate dimming mode for the lighting device, trailing or leading mode, and once the most appropriate dimming mode has been detected, selecting said mode.

US patent application US 2014312869 A1 discloses a universal lighting device control module that allows to provide a reverse phase cut dimming mode and a forward phase cut dimming mode. Said US patent application uses zero crossing information of the current signal to synchronize the inner timer of the microcontroller of the universal lighting device control module with the input power at 60/50 Hz. The above allows the microcontroller to provide a PWM control signal synchronized with the input power and thus have a smooth and flicker-free performance of the lighting device. However, said US application does not mention anything concerning the detection of the most appropriate dimming mode for the intelligent device by means of the analysis of the input voltage signal (subsequently transformed to a current signal) simultaneously in the two dimming modes, trailing and leading modes, wherein said analysis is performed in a single cycle of the sine wave analyzed. In addition, said application does not mention anything referring to selecting the most appropriate dimming mode by means of the maximum current detected, so that, if said maximum current detected is before 25% of the cycle of the sine wave analyzed, leading mode is selected, otherwise, trailing mode is selected. Also, said US application fails to disclose or suggest a method of detecting irregular behavior in the operation of a lighting device, i.e., said US application can not determine whether an intelligent device is consuming more current than it should and probably the intelligent device is in a state of deterioration. Another great difference found is that said US application does not disclose or suggest a method of detecting the type of lighting device technology, i.e., said US application can not determine whether the lighting device is an incandescent halogen device (incandescent bulb) or a compact fluorescent device (CFL) or a light-emitting diode (LED) device. As a last difference, said US patent fails to provide a method for determining the energy consumption of an intelligent device, that is, the US application does not determine how much current, and therefore, how much power the lighting device is using.

Now, US Pat. No. 9 595 880 B2 discloses a control module comprising one or more energy measuring circuits, a current measurement circuit and a voltage measurement circuit. Said current measuring circuit measures the magnitude of the load current conducted in the lighting device. Likewise, the voltage measurement circuit measures the magnitude of the voltage line of the AC power source. In turn, said US patent generates a phase control signal using standard dimming techniques to control the dimming of the lighting device. However, said US patent does not disclose data filteringto eliminate the noise present in the voltage signal and the current signal, wherein said filtering is comprised by an amplitude filtering, a frequency filtering and a magnitude filtering. Data filtering allows to ignore variations or small voltage peaks that affect the treatment and evaluation of the voltage signal and current signal analyzed. Another great difference found is that said US patent fails to disclose or suggest a method of detecting the type of lighting device technology, that is, said US patent can not determine if the lighting device is an incandescent halogen device (incandescent bulb) or a compact fluorescent device (CFL) or a light-emitting diode (LED) device. Also, said US patent fails to disclose or suggest a method of detecting irregular behavior in the operation of a lighting device, i.e., said US patent can not determine if an intelligent device is consuming more current than it should and whether said intelligent device is in a state of deterioration. Although said US patent uses standard dimming techniques to control dimming of the lighting device, it fails to disclose or suggest that the detection of the most appropriate dimming mode for the intelligent device is through the analysis of the input voltage signal (subsequently transformed to current signal) simultaneously in the two dimming modes, trailing and leading mode, wherein said analysis is performed in a single cycle of the sine wave analyzed. In addition, said application does not mention anything referring to selecting the most appropriate dimming mode by means of the maximum current detected, so that, if said maximum current detected is before 25% of the cycle of the sine wave analyzed, the leading mode is selected, otherwise, the trailing mode is selected.

Another relevant document is Japanese Patent Application JP 2001135491 A, which discloses a device comprising a first and second switch elements connected in series, said first and second lighting circuits include a resonance circuit connected in parallel with the second switch element and a fluorescent lamp for exclusive use of high frequency lighting. Said device detects, precisely, anomalies in the behavior of a fluorescent lamp, wherein said anomalies are representative of the last life cycles of said fluorescent lamp, in turn, discloses a device for fluorescent lamps that maintains a desirable lighting condition despite the anomalies in the behavior of the fluorescent lamp. Although said Japanese Patent Application discloses a method of detecting irregular behavior in the operation of a lighting device, said Japanese Patent Application is only focused on high frequency lighting devices, specifically fluorescent lamps. In contrast, the present invention is capable of detecting anomalies in any lighting device, such as an incandescent halogen device (incandescent bulb), a compact fluorescent device (CFL) and a light emitting diode (LED) device. Likewise, said Japanese Patent Application fails to disclose a method of detecting the technology type of the lighting device, nor a method of determining the energy consumption of a lighting device, nor a method of detecting and selecting a dimming mode.

U.S. Patents Nos. US 8,492,984 B2, US 9,354,643 B2, US 9,401,588 B2, US 9,572,215 B2, US 9,084,324 B2, US 5,038,081 A and US Patent Application US 2010/0101924 A1 disclose techniques for selecting dimming mode and control of a lighting device. For example, U.S. Patent No. 8,492,984 B2 refers to a method of self-detection between a dimming mode and a phase cut dimming mode; U.S. Patent No. 9,354,643 B2 is directed to an intelligent dimming solution for lighting devices such as light emitting diodes (LED) and other non-linear lighting devices; U.S. Patent No. 9,401,588 B2 is directed to a universal lighting device control module that controls the dimming of a lighting device by means of reverse phase cut dimming mode, forward phase cut dimming mode, and a hybrid dimming mode; U.S. Patent No. 9,572,215 B2 is focused on a method and apparatus for correcting an incorrect dimming operation; U.S. Patent No. 9,084,324 B2 discloses a lighting device control device, such as a light emitting diode (LED) dimming switch, which is configured to automatically determine whether to provide a reverse phase cut dimming mode or a forward phase cut dimming mode; U.S. Patent No. 5,038,081 A is directed to controlling an AC load, specifically an incandescent bulb, by means of the reverse phase-controlled dimming mode, by changing the power of the ON/OFF load during each half cycle of the sine wave; and, finally, U.S. Patent Application US 2010/0101924 A1 is directed to a switch device for controlling the state of a lighting device that includes a control element, which controls at least one sensor and sensitivity range of at least one sensor component, wherein said sensor component detects at least one condition and causes the switching device to control the state of the lighting device. However, said U.S. Patents do not mention anything regarding the detection of the most appropriate dimming mode for the intelligent device by means of the analysis of the input voltage signal (subsequently transformed to a current signal) simultaneously in the two dimming modes, trailing or leading mode, wherein said analysis is performed in a single cycle of the sine wave analyzed. Furthermore, said U.S. Patents and Application do not mention anything regarding selecting the most appropriate dimming mode by means of the maximum current detected, so that, if said maximum current detected is before 25% of the cycle of the sine wave analyzed, leading mode is selected, otherwise, trailing mode is selected. Likewise, said U.S. Patent and Application fail to disclose or suggest a method for detecting irregular behavior in the operation of a lighting device, or a method for detecting the type of lighting device technology, or a method for determining the power consumption of an intelligent device.

In addition, there are other patent applications that speak of techniques for selecting dimming mode and control of a lighting device, such as AU 198174729 A and WO 2016014957 A1. For example, the Australian Patent Application focuses on a method for controlling lighting devices in an electrical installation, which comprises the steps of modifying the waveform that is provided from the electrical installation to deliver detectable control signals of a plurality of distinctly different forms. From the foregoing, the method of said Australian Patent Application is different from the method used in the present invention, wherein the difference is that the present method uses trailing or leading dimming mode, while the Australian Application method does it differently. Now, the International Patent Application discloses a control module that determines whether the lighting devices respond effectively and automatically to a plurality of dimming control techniques. That is, the control module performs a trial and error on the lighting devices to determine the most efficient dimming mode. However, none of these documents mentions anything regarding the detection of the most appropriate dimming mode for the intelligent device by means of the analysis of the input voltage signal (subsequently transformed to the current signal) simultaneously in the two dimming modes, trailing or leading mode, wherein said analysis is performed in a single cycle of the sine wave analyzed. In addition, said application does not mention anything about selecting the most appropriate dimming mode by means of the maximum detected current, so that, if said maximum current detected is found before 25% of the sine wave cycle analyzed, the leading mode is selected, otherwise, trailing mode is selected. Also, said Patent Applications fail to disclose or suggest a method of detecting irregular behavior in the operation of a lighting device, nor a method of detecting the type of lighting device technology, nor a method of determining energy consumption of an intelligent device.

In turn, there are two U.S. Patents, US 9 250 669 B2 and US 8 476 895 B2, which disclose methods aimed to measuring the energy consumption of lighting devices. However, said U.S. Patents do not disclose data filtering to eliminate the noise present in the voltage signal, wherein said filtering is comprised by an amplitude filtering, a frequency filtering and a magnitude filtering. Data filtering allows ignoring variations or small voltage peaks that affect the treatment and evaluation of the voltage signal analyzed. Another major difference found is that said U.S. Patents do not disclose or suggest a method for detecting the type of lighting device technology, nor a method of detecting irregular behavior in the operation of a lighting device, nor a method for selecting and detecting a dimming mode. In turn, there is a Patent Application Document WO 2009099082 A1 which, likewise, is focused on measuring the energy consumption of lighting devices; however, it fails to disclose the novel differences mentioned above.

WO 2016/046814 A2 discloses techniques for switching AC power to a load via a two terminal switch device. The switch device comprises a first electrically controlled switch. When the first switch is open, only a leakage current is flowing through the switch device, supplied to an AC/DC converter for producing a low DC voltage to the switch device logic and other low-voltage circuits and for charging a capacitor. When the first switch is closed, the second switch is controlled to be conductive for allowing powering the lamp from the AC power. During part of a positive half-cycle of the AC voltage, a closed loop regulates a DC voltage over the second switch terminals for providing a low DC voltage for charging a capacitor. At least during a negative half-cycle of the AC voltage, the low DC voltage is provided from the capacitor.

CA 2 627 768 C discloses an apparatus in an electronic control system allows two or three wire operations. A power supply can supply power to the enclosed circuity in both two and three wire installations. Two separate zero cross detectors are used such that timing information can be collected in both two or three wire installations and are monitored and are used to automatically configure the electronic control. Over voltage circuity senses an over voltage condition across a MOSFET which is in the off state and turns the MOSFET on so that it desirably will not reach the avalanche region. Over current circuity senses when the current through the MOSFET's has exceeded a predetermined current threshold and then turns the MOSFETs off so they do not exceed the MOSFETs' safe operating area (SOA) curve. Latching circuity is employed to keep the protection circuity in effect even after a fault condition has cleared. Lockout circuity is used to prevent one protection circuit from tripping after the other circuit has already tripped from a fault condition. The protection circuity output is desirably configured such that it can bypass and override the normal turn on and turn off impedance and act virtually directly on the gates of the MOSFETs.

On the other hand, a large number of control systems for wireless lighting devices contemplate radio communication modules, thus using conventional topologies such as tree and star for their operation, which imply a deficiency in their communication because the radio signals have problems in the signal reception strength due to obstacles inherent to the building such as walls, doors, windows, etc.

Therefore, it is desired a two-wire smart switch and dimmer power supply that works continuously, does not need more than one adapter for low power lighting loads, and is able to perform forward and reverse phase control dimming, measure the power consumption, adapt according to the necessities of the lighting load and communicate efficiently with other devices.

Taking into account the differences and defects of the prior art, it is notable that the prior art mentioned in the preceding paragraphs fails to disclose or suggest the novel and inventive technical features of the present invention.

### SUMMARY OF THE INVENTION

The invention is defined in the appended claims.

The present invention discloses an intelligent switch device configured to be installed without the need to modify a conventional electrical installation found in homes.

The present invention discloses a system using an intelligent switch device capable of communicating with other intelligent switch devices and a central control system.

The present invention discloses a system using a plurality of intelligent switch devices that directly establish a communication network between a central control system and intelligent switching devices.

The present invention discloses a system using a plurality of intelligent switch devices that establish a communication network between the central control system and an intelligent switch device by means of other intelligent switch devices.

The present invention discloses a Power Supply or Electric Power System for intelligent or smart switch and dimmer devices able to switch on/off any kind of lighting load or dim a dimmable lighting load, configured to be installed in a conventional home electrical installation for two-wire switch boxes that are able to switch up to three independent lighting loads as in a 3 gang switch, without the need to modify the electrical wiring installation. The smart switch and dimmer are also able to work with a three-wire configuration (phase/hot, neutral and the wire from the load). If the three wires are available in the switch box, the user is able to select whether to use two or three wires.

The Power Supply supplies enough power for a variety of peripherals and components of the smart switch and dimmer, e.g. a wireless communication module, a user interface with LEDs, and a microprocessor or microcontroller. The supply of power is constant and is not affected by whether there are one, two or three independent lighting loads in the case of the switch and one load in the case of the dimmer.

When the lighting loads are off, the Power Supply closes the circuit by letting a small amount of current to pass from the AC mains through one of the lighting loads, thus obtaining energy for powering the smart switch and dimmer components. The current passing through the lighting load should be small enough to not let the lighting load turn on. If the lighting load is a low power lighting load (e.g. an LED or CFL), an adapter parallel to the load may be used in order to avoid the flicker of the same. There is no need to use additional adapters if there are more lighting loads connected to the smart switch in a 2 or 3 gang configuration.

The Power Supply is also able to measure the power consumed by the loads and determining what kind of lighting load is connected to the same (LED or incandescent bulbs) via a microcontroller or microprocessor by outputting a voltage signal proportional to the current consumed flowing through the lighting loads.

Furthermore, depending on the type of the lighting load (resistive or capacitive loads), the dimming mode should vary accordingly. Resistive loads like incandescent light bulbs, are best dimmed with a leading edge pattern or forward phase control; while capacitive loads like the drivers of LED lights are best dimmed with a trailing edge pattern or reverse phase control. The power supply is able to operate in the two dimming modes: trailing edge and leading edge and has a zero crossing detection module for the AC voltage of the electric installation for synchronizing the dimming with the phase of the AC mains voltage.

Additionally, the Power Supply is compatible with American and European switch boxes and electrical standards, i.e. 110-120 Volts and 60 Hz or 220-240 Volts and 50 Hz.

The present invention also discloses a method to for the smart switch to perform different functions such as: determination of electrical/energy consumption of the lighting devices connected in each way or circuit of the smart switch and dimmer, detecting or determining the type of lighting devices connected in each way of the smart switch and dimmer, detecting irregular behavior in the operation of lighting devices connected to the smart switch and dimmer, for a smart dimmer device, the method performs a function that allows to automatically select the most appropriate dimming mode for a lighting device depending on the type of technology connected thereto, to achieve proper operation of the same.

Lighting device operating parameters may be communicated to an external supplier of lighting devices, which can offer new lighting products in order to reduce power consumption or to replace a damaged lighting device, or such data can be used for a statistic record of the energy consumption per minute, hour, day, week, month and year.

It is worth mentioning that said method can perform the functions together or individually. The method can be performed at the beginning of the installation of the smart switch or dimmer, when the user requests it in the installation of new lighting devices and/or when the central control system requests said information.

Throughout the description of the present invention indistinct terms and their variants will be used which do not affect the scope of the present invention, said terms are obvious and understandable to a person skilled in the art. When the term lighting device is used, it can be understood as a lighting load or a bulb or any synonym thereof and that can be any type of technology, such as; resistive, halogen, LED, CFL or other types of technologies known for lighting. When the term current consumption is used, reference is also made to electric current consumption. When the term line wire is used, it can be understood as phase, hot or line wire. When reference is made to energy consumption, it also refers to power or electrical energy consumption. When the term smart switch is used, it also refers to intelligent switch, smart switch device, intelligent switch device, smart dimmer, intelligent dimmer or any synonym thereof.

### BRIEF DESCRIPTION OF THE DRAWINGS

The invention may be better understood by referring to the following figures.

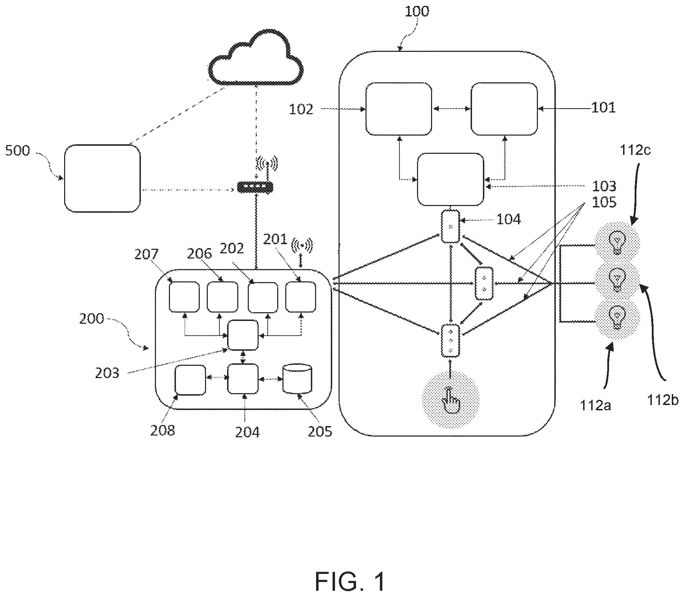

Fig. 1 is a general view of the system depicting a smart switch and a central control system.
Fig. 2 is an electrical diagram in the case when the power supply is energized by only two wires of the electrical installation.
Fig. 3 is a view of the central control system of the present invention.
Fig. 4 is a block diagram depicting the functioning of a first embodiment of the Power Supply in a switch configuration.
Fig. 5 is an electrical diagram of a preferred embodiment of the high power module for a switch configuration.
Fig. 6 is an electrical diagram of a preferred embodiment of the third low power module.
Fig. 7 is an electrical diagram of a first embodiment of the current sensing circuit for the switch and dimmer configurations.
Fig. 8 is a block diagram depicting the functioning of a second embodiment of the Power Supply in a switch configuration.
Fig. 9 is a preferred embodiment of the zero crossing detection module for the switch configuration.
Fig. 10 is an electrical diagram of a second embodiment of the current sensing circuit for the switch configuration.
Fig. 11 is a block diagram depicting the functioning a first embodiment of the Power Supply in a dimmer configuration.
Fig. 12 is an electrical diagram of a preferred embodiment of the high power module for a dimmer configuration.
Fig. 13 is an electrical diagram of a first embodiment of the zero crossing detection module for a dimmer configuration.
Fig. 14 is a block diagram depicting the functioning a second embodiment of the Power Supply in a dimmer configuration.
Fig. 15A is a general scheme of the functions performed in the smart switch.
Fig. 15B is a general scheme of the functions performed in the smart dimmer.
Fig. 16 is a general scheme of a circuit for measuring the current consumption of a lighting device.
Fig. 17 is a flowchart of the steps performed by the function for determining the current consumption of a lighting device.
Fig. 18 is a flowchart of the steps performed by the technology type determination function of a lighting device.
Fig. 19 is a flowchart of the steps performed by the function detecting irregular behavior in the operation of a lighting device.
Fig. 20 is a flowchart of the steps performed by the dimming mode detection and selection function according to the type of lighting device.
Fig. 21 is a figure showing the dimming mode used in the method applied in an AC wave cycle.
Fig. 22 is a figure showing the abrupt consumption of current as a response of the lighting device to the dimming mode used by the method applied in an AC wave cycle.
Fig. 23 is a flow chart of the functions integrating the method as a whole.

### DETAILED DESCRIPTION OF THE INVENTION

The power supply 101, also called Electrical Power System (EPS) or power module, has four embodiments: two for a switch configuration and two for a dimmer configuration of the smart switch device 100. The power supply 101 generally has a low power module or modules for generating a DC low voltage, a high power module which turns on or off the lighting loads 107a, 107b and 107c connected to lines 105, a current sensing module which allows to measure the power consumption, the type of technology of a lighting load (i.e. if the lighting load is a resistive, CLF or LED type) and an abnormal behavior of the lighting load to predict if the same is about to fail or break. The power supply 101 is in charge of energizing the electronics of the control module 102, the user interface 103 and the communications module 104. The power supply 101 is designed to be installed in a standard European or American type switch box, so it can be coupled to any type of existing electrical installation, both at 110-120 Volts and 220-240 Volts AC at 60 or 50 Hertz, and can support up to three different lines 105 per each switch box.

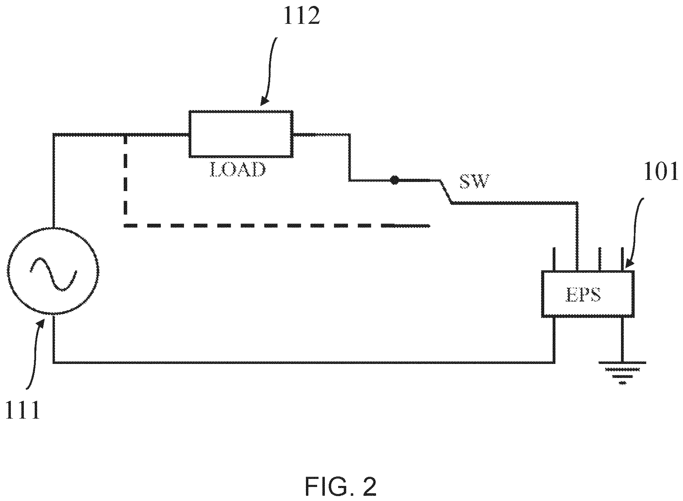

The power supply 101 may operate connected only to phase or only to neutral and to the wire from the lighting load, which is commonly named in the art a two-wire configuration; or connected to both phase and neutral and to the wire from the lighting load, which is commonly named in the art a three-wire configuration, and in both embodiments power is provided uninterruptedly to the smart switch device 100, regardless of the state (on or off) of the lighting loads. The fact that it can operate in a two-wire configuration allows the smart switch 100 to be installed in a conventional electrical installation, in which only two wires arrive to each switch box. This two-wire configuration is illustrated in Fig. 2, wherein there are only the wires from the phase of the AC mains 111 and the wire from the load arriving to the power supply 101. A dashed line depicts the neutral wire that can be used if it is present in the switch box.

The power supply 101 modifies its operation according to the type of supply mode:
In a three-wire configuration, the smart switch device 100 is able to control any type of load of a lighting device regardless of its current demand, since the electronics circuit is fed by an independent circuit to the load of the lighting device.

In a two-wire configuration, the smart switch device 100 receives from the electrical installation a continuous supply of power for its operation by closing the circuit to which it is connected. The smart switch device 100 allows the passage of current therethrough and the lighting load, said current allows for the operation of the smart switch device 100, but is less than the current needed for the lighting device to be turned on. In the event that the lighting device or load is a low energy or low power consumption device, the current passing therethrough may be sufficient for it to light up or flash. In the latter case, an adapter for low energy consumption devices may be connected in parallel to said lighting device to prevent it from turning on or flashing.

The control module 102 of the smart switch device 100 is responsible for coordinating, controlling and receiving information from the communication 104 and power 101 modules, the user interface 103 and all peripherals of the smart switch device 100. In a preferred embodiment, the control module 102 performs these functions by means of a microcontroller.

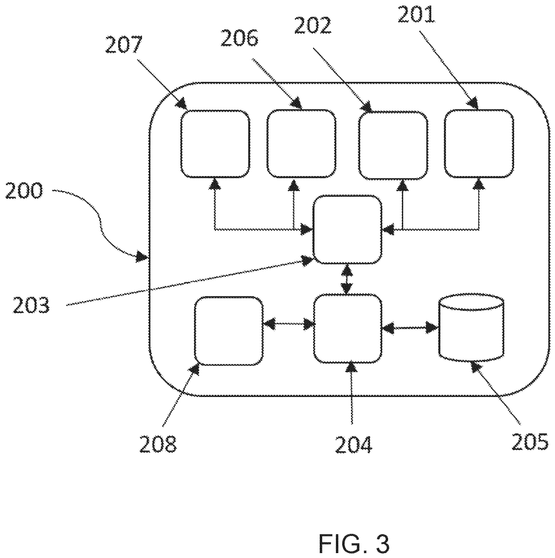

Some specific functions of the control module 102 include, but are not limited to: enabling or disabling the power supply 101 to energize or de-energize a line 105, thereby turning on or off a lighting device connected to said line 105; providing acoustic and optical sensory feedback, such as emitting different sounds and/or activating LED indicators by activating the smart switch device 100 or by turning on or off a lighting device; performing a registry of the power consumed by each line 105 using a current sensor; sending and receiving information and commands from the central control system 201 which is depicted in Fig. 3; and causing the smart switch device 100 to enter a sleep mode when no command is received from the user after a predetermined time, which is disabled when it is detected that a user has brought his/her hand close to the user interface 103.

A current sensing module detects the current consumed by each line 105 to calculate the electrical consumption of the lighting devices, in order to perform a registry of the power consumption, which is sent by the communications module 104 to a database of the central control system 200, which performs a statistical registry of consumption per minute, hour, day, week, month and year. This registry may be communicated to an external lighting device provider, which may offer new lighting products in order to reduce the energy consumption of the electrical installation or to replace a defective lighting device.

The communications module 104 performs the communication between the control module 102 of the smart switch device 100 and the central communications module 201 of a central control system 200; in order to exchange information about the state of the smart switch device 100, receive services and commands for the operation of the smart switch device 100, such as turning on and off a lighting device or receiving firmware updates for the smart switch device 100. Additionally, the communications module 104 of the smart switch device 100 may report its status to the central control system 200, as well as send an acknowledge signal if a command is successfully performed, said signal can be used for generating a prompt for the user on a remote user interface 500, such as a smart phone or computer, when his/her command is executed successfully.

The communications module 104 performs the communication wirelessly. In a preferred embodiment, said wireless communication is performed in the encrypted 433 MHz radio band and can operate at transfer rates from 1200 to 300,000 bits per second.

The user interface 103 of the smart switch device 100 is responsible for receiving user inputs for controlling the powering, on or off, and intensity or dimming of the lighting device(s) connected to the lines 105, which are sent to the control module 102 for performing said operations. In a preferred embodiment, the user interface 103 comprises a touch interface and the user inputs comprise tactile gestures; the user interface 103 may also comprise LEDs and a speaker or buzzer to provide information to the user about the status of the smart switch device 100. The user interface 103 may also adapt its LED indicators depending on the number of connected lines 105, turning on the number of LEDs corresponding to the number of connected lines 105. In another embodiment, the user interface 103 may comprise a voice operated interface; and in yet another embodiment, the user interface 103 may be a three-dimensional touch interface controlled by tactile and proximity gestures. In a further embodiment, the smart switch device 100 can be restored to its factory settings by a predetermined gesture at the touch interface.

In a preferred embodiment, the smart switch device 100 enables the user interface 103 to be turned on and off by means of the remote user interface 500. The smart switch device 100 may be automatically enabled or disabled by the remote user interface 500 when the user enters or leaves a geofence defined by the user.

Now, turning back to the power supply 101, the same has four different configurations: power supply 101a which is a first embodiment of a power supply for a smart switch; power supply 101b which is a second embodiment of a power supply for a smart switch; power supply 101c which is a first embodiment of a power supply for a smart dimmer; and power supply 101d which is a second embodiment of a power supply for a smart dimmer. These configurations will be further explained below.

### First embodiment of the power supply for a smart switch

The Power Supply 101a, has five submodules: A first low power module 106, a second low power module 107, a third low power module 108, a high power module 109 and a current sensing module 110. The Power Supply 101a is connected with up to three lighting loads 112a, 112b and 112c and to the AC mains 111.

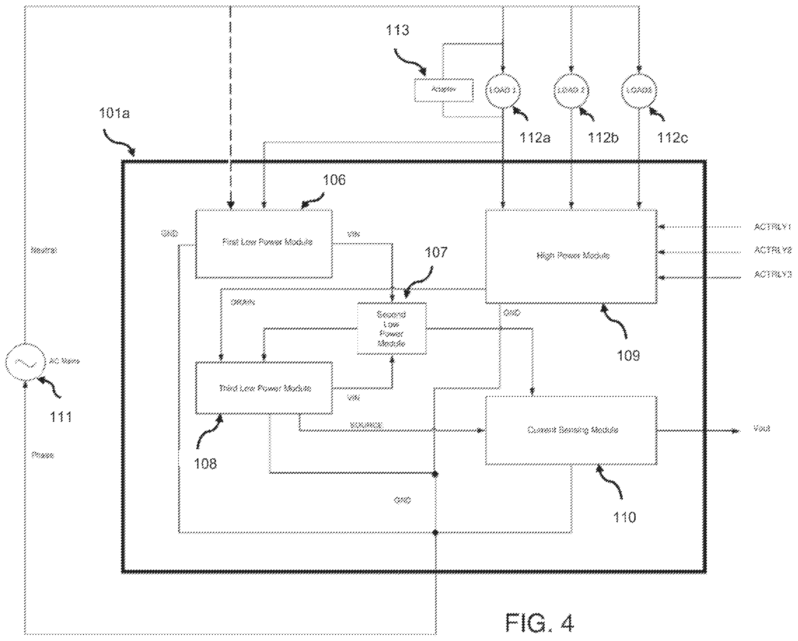

An overall description of the system is as follows. A first mode of operation is implemented when there are three wires available in the switch box: phase wire, neutral wire and the lighting load wire. The neutral and phase wires of the AC mains 111 are connected and supplying power directly to the first low power module 106. The third wire (neutral) is depicted in Fig. 4 as a dashed line.

Usually there are only two wires available in the switch box for a single switch (not taking into account the earth or ground wire). The two wires that are usually located in a switch box are the phase wire and the wire from the lighting load. There are 2 or 3 gang switches that control two or three independent loads, but they still lack the neutral wire. It is to be noted that, in some electrical installations, the phase wire may be absent from the switch box and replaced with the neutral wire. If this is the case, the Power Supply 101a is able to operate with the neutral wire and the wire from the lighting load. For illustrative purposes, the wire coming from the AC mains will be treated as the phase wire, since the functioning of the Power Supply 101a remains the same. The Power Supply 101a has a selector switch for selecting between the first or the second modes of operation, depending on the availability of the neutral wire in the switch box at the time of installation.

If there are two wires only in the switch box, the second mode of operation is used. This second mode of operation is composed by two cases, when the load 112a is in its on state and when the same is in its off state. The case when the load 112a is in its off state will be described first.

### Off State Functioning

In this case, power is needed to feed the electronic circuits that control the smart switch and other peripheral circuits, such as a communications module, or a user interface. The wire from the first load, load 112a, is connected to the first low power module 106 and the high power module 109. When the load 112a is in its off state, current will flow only through the first low power module 106, since the high power module 109 will act as an open circuit. Thefirst low power module 106 accesses the neutral wire needed to close the circuit via the load 112a, by letting a small current pass through the lighting load 112a and the Power Supply 101a itself.

If the load 112a is a low power lighting load like a Compact Fluorescent Lamp (CFL) or a Light Emitting Diode (LED), the current flowing through the lighting load 112a and the Power Supply 101a may be enough to make the lighting load flicker, or it may be even that the impedance of the lighting load is low enough for it to illuminate. A single low power lighting load adapter 113 may be connected in parallel to the lighting load to prevent these unwanted effects. The low power lighting load adapter 113 provides an additional path for the current to flow, therefore limiting the current that flows through the lighting load 112a. Lighting loads 112b and 112c do not need a low power lighting load adapter. The low power lighting load adapter 113 may comprise resistive, capacitive, inductive elements, or a combination thereof.

When the lighting load 112a is in its off state, a relatively small current flowing through the Power Supply 101a powers the first low power module 106, which receives the power from the AC mains 111 and outputs a constant first level DC voltage (Vin). In a preferred embodiment, the first low power module 106 is implemented by means of a non-isolated flyback converter that includes a High Precision CC/CV (Constant Current/Constant Voltage) Primary-Side PWM Power Switch.

The voltage Vin is fed into a second low power module 107, which steps down the voltage to a second level DC voltage (Vlow). The Vlow is used to power components of the smart switch 100 such as the control module 102 which controls and commands the switching on or off of the lighting loads 112a, 112b and 112c. In a preferred embodiment, the second low power module 107 is implemented by means of a buck converter.

### On State Functioning

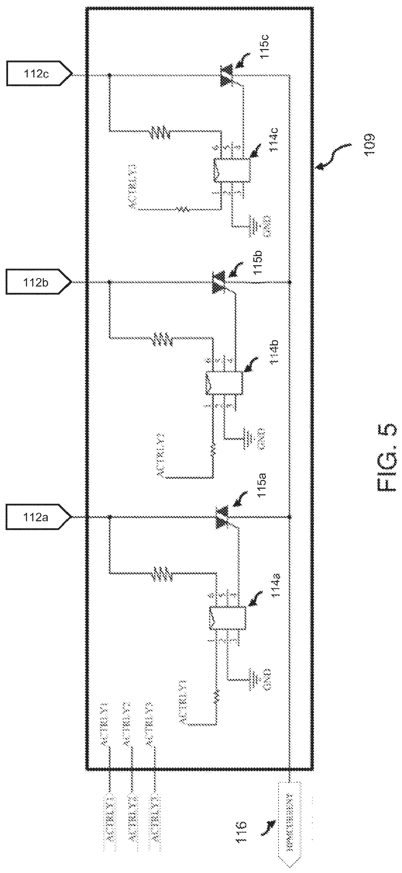

Fig. 5 depicts a preferred embodiment of the high power module 109. The controller module 102 sends activation signals ACTRLY1, ACTRLY2 and ACTRLY3 that are employed to trigger a circuit that switches on or off the lighting loads 112a, 112b and 112c. The circuit that switches on or off the lighting loads has an isolation stage that isolates the external microcontroller from the AC mains 111 power, implemented by means of opto-isolators 114a, 114b and 114c, which receive the activation signals ACTRLY1, ACTRLY2 and ACTRLY3 and let current to flow into the gate of TRIACs 115a, 115b and 115c, that are connected in series to the lighting loads 112a, 112b and 112c, respectively. In response to the activation signals ACTRLY1, ACTRLY2 and ACTRLY3, the terminals of the TRIACs 115a, 115b and 115c act as a short circuit, allowing the AC mains 111 current to flow through the lighting loads 112a, 112b and 112c.

If load 112a is switched on, the voltage drop on the same is almost of the same magnitude as the AC mains voltage 111. This causes a voltage divider effect that leaves almost no voltage in the first low power module 106, causing a short circuit effect, therefore, leaving the Power Supply 101a with not enough voltage to function. To overcome this issue, the current that goes through the TRIACs 115a, 115b and 115c exits the high power module 109 (HPMCURRENT 116) and enters the third low power module 108 that deviates a fraction of the HPMCURRENT current 116 to keep the powering the Power Supply 101a.

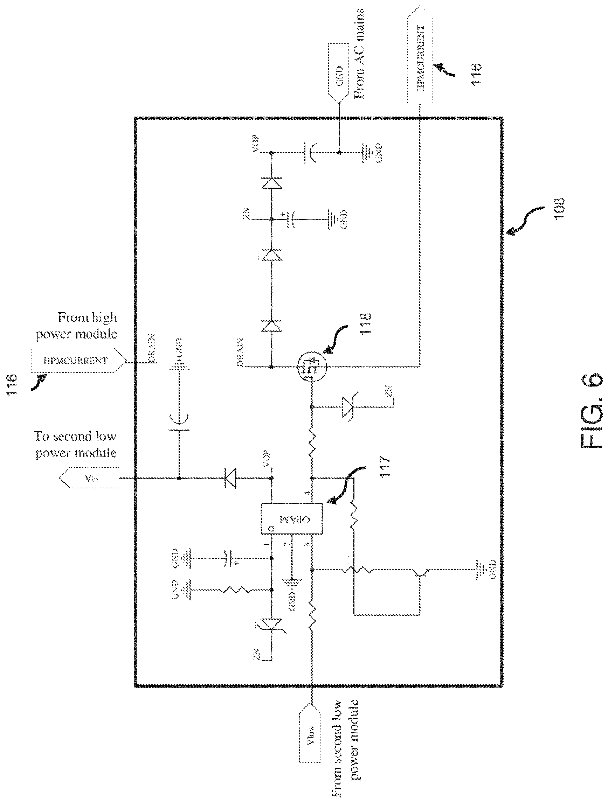

A preferred embodiment of the third low power module 108 is depicted in Fig. 6. The third low power module 108 provides power to the Power Supply 101a from HPMCURRENT 116 when the load 112a is in its on state.

The HPMCURRENT 116 enters the third low power module 108 and part of it is rectified and regulated to generate a first level low voltage (Vin). In a preferred embodiment, the rectification and regulation is performed by means of an arrangement of diodes and Zener diodes. The third low power module 108 is used to feed the second low power module 107, since the current supplied by the first low power module 106 is not enough to keep the Power Supply 101a functioning. Vin is also used to supply power to a comparator, which in a preferred embodiment comprises of an OPAMP 117 that compares the second level low voltage Vlow with the rectified voltage and outputs an oscillating signal that activates and deactivates the gate of the MOSFET 118, which allows and prevents the HPMCURRENT 116 to exit the third low power module 108.

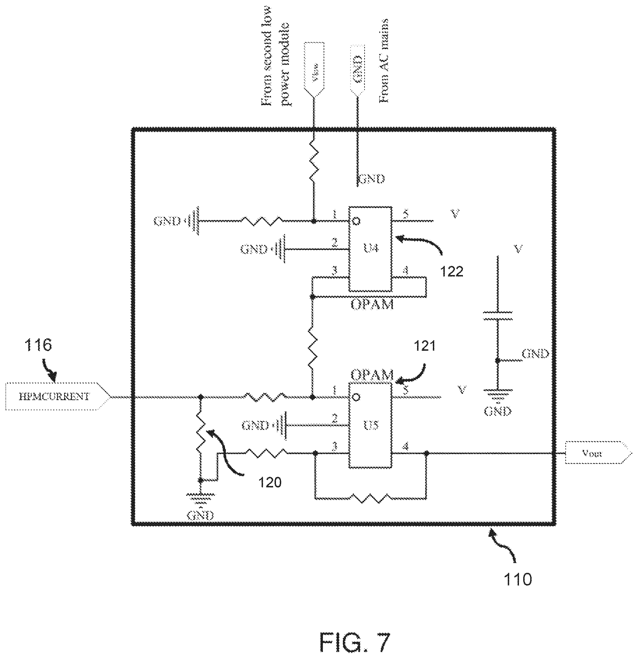

The HPMCURRENT 116 enters the current sensing module 110, as depicted in Fig. 7, which converts the HPMCURRENT 116 into a voltage signal (Vout) to be fed to the ADC module of the controller module 102. The current sensing module 110 is arranged in such a way that the HPMCURRENT 116 passes through a shunt resistor 120 which allows a small current to pass through an amplifying stage, which in a preferred embodiment is performed by means of the OPAMP 121 which amplifies the signal of the HPMCURRENT 116, and additionally the OPAMP 122 adds an offset voltage to the signal of the HPMCURRENT 116 and outputs Vout, in order to make the Vout voltage compatible with the voltage level of the ADC module of the control module 102.

Both cases (on state functioning and off state functioning) allow for the control module 102 to be energized by the second low power module 107, which is always powered by either the first low power module 106 or the third low power module 108. Therefore, the high power module 109 is able to switch on or off all loads, regardless of the state of lighting loads 112b and 112c.

### Second embodiment of the power supply for a smart switch

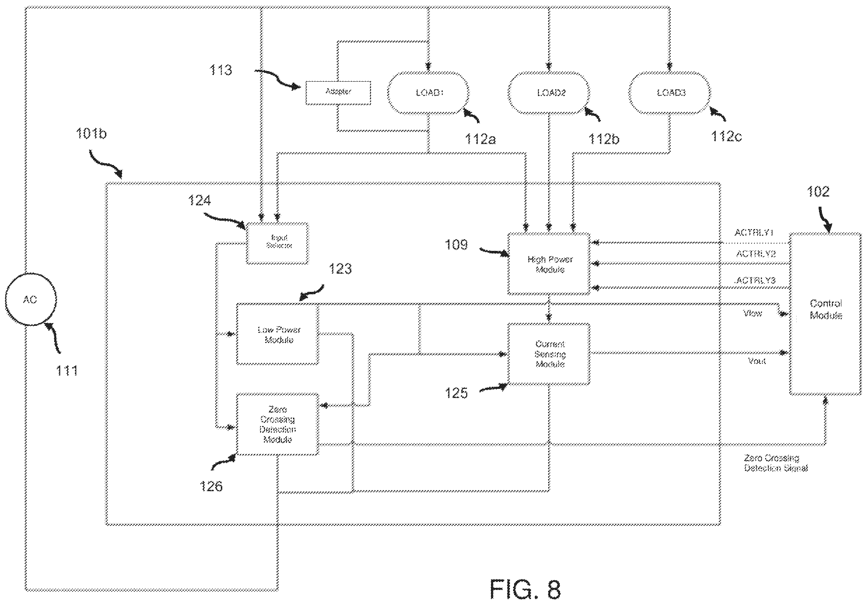

Now, referring to Fig. 8, the Power Supply 101b has five submodules: a low power module 123 that converts directly from AC to the second level DC voltage (Vlow), an input selector 124 for automatically selecting between the three-wire or the two-wire configurations, a high power module 109 as the one described in the embodiment of the Power Supply 101a, and depicted in Fig. 5, a current sensing module 125, a zero crossing detection module 126, lighting loads 112a, 112b, 112c and a low power lighting load adapter 113 as the one described in the embodiment of the Power Supply 101a.

### Off State Functioning

In this case, the wire from the first lighting load, lighting load 112a, is connected to the input selector 124 and the high power module 109. When the lighting load 112a is in its off state, current will flow only through the input selector 124, since the high power module 109 will act as an open circuit. The input selector 124 leads to the low power module 123 that accesses the neutral wire needed to close the circuit via the load 112a, by letting a small current pass through the lighting load 112a and the Power Supply 101b itself.

If the load 112a is a low power lighting load like a Compact Fluorescent Lamp (CFL) or a Light Emitting Diode (LED), the current flowing through the lighting load 112a and the Power Supply 101b may be enough to make the lighting load flicker, or it may be even that the impedance of the lighting load is low enough for it to illuminate. A single low power lighting load adapter 113 may be connected in parallel to the lighting load to prevent these unwanted effects. Lighting loads 112b and 112c do not need a low power lighting load adapter.

When the lighting load 112a is in its off state, a relatively small current flowing through the Power Supply 101b powers the low power module 123, which receives the powerfrom the AC mains 111 and outputs the constant second level DC voltage (Vlow). In this embodiment of the Power Supply, the electronic components are galvanically isolated from the AC current from AC mains 111. The isolation in the low power module 123 is implemented by a flyback converter with a high voltage flyback switcher circuit and an isolated transformer, which outputs the second level DC voltage (Vlow) with ground isolated from the AC mains 111 that is necessary to power the zero crossing detection module 126, the current sensing module 125 and the control module 102.

### On State Functioning

Referring to Fig. 5 again, the activation signals ACTRLY1, ACTRLY2 and ACTRLY3 are used to trigger a circuit that switches on or off the lighting loads 112a, 112b and 112c in the high power module 109. In this module, the galvanic isolation is performed by means of opto-isolators 114a, 114b, 114c, which receive the activation signals and let current to flow into the gate of TRIACs 115a, 115b and 115c, that are connected to the lighting loads 112a, 112b and 112c, respectively. In response to the activation signals ACTRLY1, ACTRLY2 and ACTRLY3, the terminals of the TRIACs 115a, 115b and 115c act as a short circuit, allowing the AC mains 111 current to flow through the lighting loads 112a, 112b and 112c. The activation signals ACTRLY1, ACTRLY2 and ACTRLY3 are provided by the control module 102.

As explained above, if the lighting load 112a is switched on, the voltage drop on the same is almost of the same magnitude as the AC mains voltage 111. To overcome this issue, the control module 102 needs to detect when the AC mains 111 crosses zero, in order to draw a small amount of current just after the AC wave crosses zero and then turn on the lighting load 112a. The zero crossing detection module 126 is responsible for sending the zero crossing detection signal to the external microcontroller. The external microcontroller then waits for a period of time after the zero crossing detection before sending the activation signal ACTRLY1. In this period of time the lighting load 112a is off and the low power module 123 receives enough power to operate until the next zero crossing. With this configuration, the lighting loads 112b and 112c do not need to be turned off after the zero crossing and may be in its on state all the time, since their circuits are independent of the low power module 123.

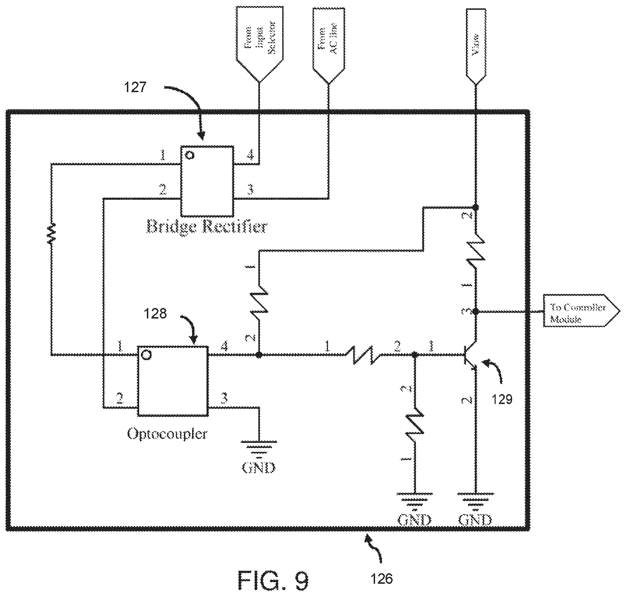

The zero crossing detection module 126 is depicted in Fig. 9 and employs a bridge rectifier 127 connected to the AC voltage from the input selector 124 and the phase wire from the AC mains 111. The rectified AC signal is outputted to an opto-isolator or optocoupler 128 that galvanically isolates the zero crossing module from the AC mains 111. The output of the opto-isolator 128 is received by the base of the transistor 129. The transistor 129 then outputs a HIGH signal (Zero Crossing Signal) to the control module 102 when the current in its base is zero, i.e., when the AC wave crosses zero, in order to control the timing of the turning on or off of the lighting load 112a. The current that goes through the TRIACs 115a, 115b and 115c (HPMCURRENT 116) exits the high power module 109 and enters the current sensing module 125 for measuring the power consumption of the lighting loads.

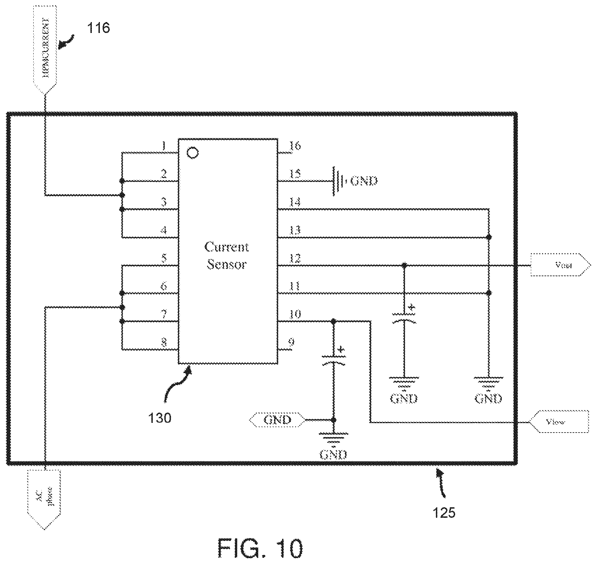

A preferred embodiment of the current sensing module 125 is depicted in Fig. 10, which converts the HPMCURRENT 116 that exits the high power module 109 into a voltage signal (Vout) to be fed to the ADC of the control module 102. In this embodiment of the Power supply 101 (Power Supply 101b), the current sensing module 125 is galvanically isolated from the AC mains 111. The current sensing module 125 may perform the galvanic isolation with a device such as a hall effect sensor 130. The hall effect sensor 130 measures the HPMCURRENT 116 and converts it to a Vout voltage. Vout is sent to the ADC module of the control module 102 in order to calculate the power consumption of the lighting loads 112a, 112b and 112c. Vout is also used to determine the type of technology connected to the smart switch, i.e., incandescent, CFL or LED bulb.

### First embodiment of the power supply for a smart dimmer

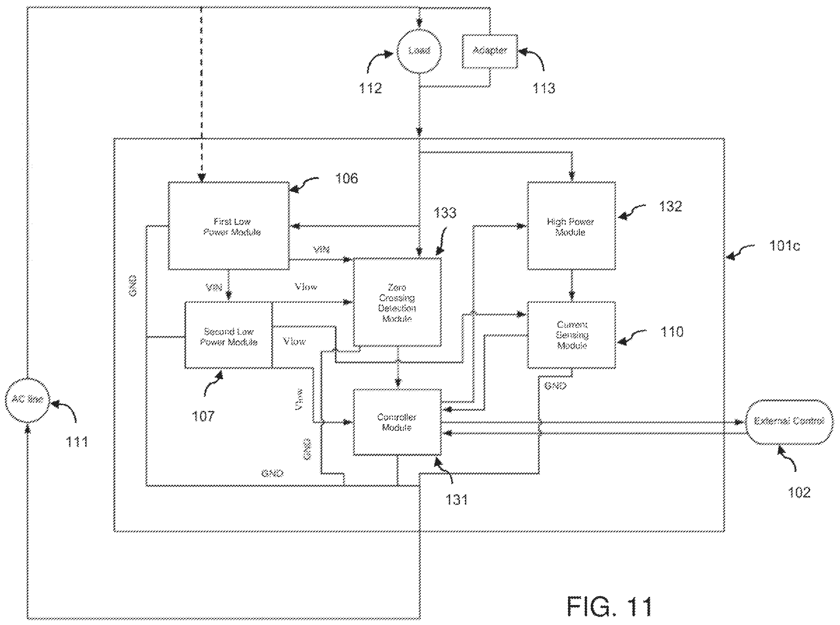

Fig. 11, depicts the Power Supply 101c which may be used when the smart switch device 100 is configured as a smart dimmer. The Power Supply 101c six main submodules: A first low power module 106, a second low power module 107, a controller module 131, a high power module 132, a current sensing module 110, and a zero crossing detection module 133, a lighting load 112 and a low power lighting load adapter 113. The Power Supply 101c is connected to the lighting load 112, and to the AC mains 111. An overall description of the system is as follows.

A first mode of operation is implemented when there are three wires available in the switch box: phase, neutral wire and the lighting load wire, not taking into account the ground or earth wire. The neutral and phase wires of the AC mains 111 are connected and supplying power directly to the first low power module 106. The neutral wire is depicted in Fig. 11 as a dashed line. In this mode of operation, the power supply 101c operates in a conventional way, obtaining power from the AC mains 111 directly for the electronic components of the smart dimmer to operate correctly.

When there are only two wires available at the switch box, the second mode of operation is employed. It is to be noted that, in some electrical installations, the phase wire may be absent from the switch box and replaced with the neutral wire. If this is the case, the power supply 101c is able to operate with the neutral wire and the wire from the lighting load. For illustrative purposes, the wire coming from the AC mains will be treated as the phase wire. The Power Supply 101c has a selector switch for selecting at the time of installation between the first or the second modes of operation, depending on the availability of two or three wires in the switch box.

In this second mode of operation, power is needed all the time to feed the electronic circuits that control the operation of the smart switch and peripheral circuits, such as a communications module 104, user interface 103, or control module 102, regardless of the state (on or off) of the lighting load 112. To accomplish this, the wire from the lighting load 112 is connected to the first low power module 106 and the high power module 132. When the lighting load 112 is in its off state, the high power module 132 will act as an open circuit and current will flow only through the first low power module 106. The first low power module 106 is connected directly to the phase wire and indirectly to the neutral wire via the load 107, thus closing the circuit by letting a small current pass through the lighting load 112 and the Power Supply 100 itself, in such way that the small current should not allow to illuminate the lighting load 112.

If the lighting load 112 is a low power lighting load like a Light Emitting Diode (LED), the current flowing through the lighting load 112 and the Power Supply 101c may be enough to make the lighting load flicker, or it may be even that the impedance of the lighting load is low enough for it to illuminate. A low power lighting load adapter 113 may be connected in parallel to the lighting load 112 to prevent these unwanted effects. The low power lighting load adapter 113 provides an additional path for the current to flow due to its lower impedance, therefore it can limit the current that flows through the lighting load 112.

When the lighting load 112 is in its off state, a relatively small current flows through the low power lighting load adapter 113, the lighting load 112 and the Power Supply 101c and powers the first low power module 106, which receives the power from the AC mains 111 and outputs a constant first level DC voltage (Vin). In a preferred embodiment, the first low power module 106 is implemented by means of a flyback converter that includes a High Precision CC/CV (Constant Current/Constant Voltage) Primary-Side PWM Power Switch.

The voltage Vin powers a second low power module 107, which steps down the voltage to a second level DC voltage (Vlow) that is used to power the controller, current sensing and zero crossing detection modules 131, 110 and 133. The zero crossing detection module 133 detects the zero crossings of the AC mains 111 voltage to send said detections to the controller module 131 to control the dimming of the lighting load 112. In a preferred embodiment, the second low power module 107 is implemented by means of a buck converter.

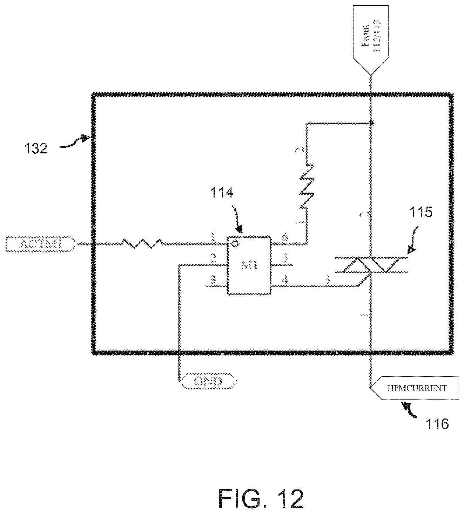

Referring to Fig. 12, the controller module 131 sends an activation signal ACTM1 that is used to trigger the high power module 132 to turn on or off the lighting load 112, in order to control the dimming of the same. To protect the low power electronic components of the controller module 131, the circuit that switches on or off the lighting load has an isolation stage that electrically isolates the controller module 131 from the AC mains 111 power. In a preferred embodiment the isolation is implemented by means of an opto-isolator or optocupler 114 which receives the activation signal ACTM1 from the controller module 131 and lets current to flow into the gate of a bidirectional semiconductor or controllably conductive device to activate or deactivate the conduction of the same. In a preferred embodiment the bidirectional semiconductor or controllably conductive device is implemented by TRIAC 115. The TRIAC 115 is connected in series to the lighting load 112. In response to the activation signal, the terminals of the TRIAC 115 act as a short circuit, allowing the AC mains 111 current to flow through the lighting load 112 and low power lighting load adapter 113 (if applicable).

If the lighting load 112 illuminates at a high intensity (e.g. at a 100% duty cycle), the voltage drop on the same is almost of the same magnitude as the AC mains voltage 111. This causes a voltage divider effect that causes a short circuit effect that leaves almost no voltage in the first low power module 106, and therefore, leaving the Power Supply 101c without enough voltage to function. In order to overcome this issue, the lighting load 112 is not allowed to operate beyond a maximum duty cycle, which in a preferred embodiment said duty cycle is 85%. If the Power Supply 101c is operating in the maximum duty cycle, the remaining 15% of the cycle the lighting load 112 is in off state. When the lighting load 112 is in its off state, there is a voltage between the terminals of the power supply 101c, which powers the first low power module 106. During said 15% of cycle the first low power module 106 draws enough current to supply power to the smart switch in order to keep it functioning until the lighting load is in its off state again in a subsequent cycle.

The dimming is controlled by means of the controller module 131. The controller module 131 is responsible for receiving a dimming percentage value from the control module 102. Said dimming percentage value may be inputted to the smart dimmer by a user on the user interface 103 or the remote user interface 500. The activation signal ACTM1 is timed so as to be in sync with the phase of AC mains 111, otherwise the lighting load 112 will flicker. The timing of ACTM1 is calculated by detecting the zero crossings of the AC voltage of the AC mains 111.

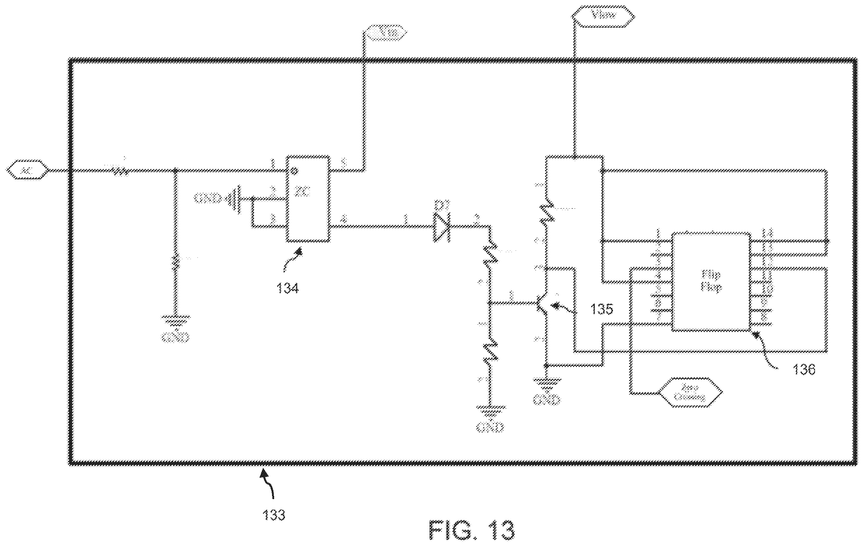

The power supply 101c is able to work as either a trailing edge dimmer or a leading edge dimmer. To control the dimming of the lighting load 112, careful timing is needed to send the activation signal ACTM1 to trigger precisely the TRIAC 115 into conduction, according to the lighting duty cycle requested by the user. Some lighting loads modify the frequency of the current passing through them, which may cause the controller module 131 to detect zero crossings that are not in sync with the phase of the AC mains 111, thus affecting the timing of the activation signal ACTM1. To overcome this, the Zero Crossing signal from the zero crossing detection module 133 is used to detect the zero crossing of the voltage from the AC line. The zero crossing detection module 133 employs a comparator 134 in a non-inverting configuration, as shown on a preferred embodiment in Fig. 13. The inputs of the comparator 134 are ground (GND) and an AC voltage whose input is the terminal labeled AC, which comes from the input of the first low power module 106, and passes through a voltage divider in order to lower the AC voltage to a level compatible with the comparator 134. The comparator 134 is polarized by Vin from the first low power module 106 and ground. When the voltage of the AC mains 111 is positive the comparator 134 will saturate positively, and when the voltage is negative, the comparator 134 will saturate negatively outputting ground level. The output of the comparator 134 is connected to a latching circuit, that in a preferred embodiment is implemented by means of a transistor 135 and flip flop circuit 136. The transistor 135 receives the output from the comparator 134 and when the output of the comparator is at ground level, the transistor sends a HIGH signal to the clock of the flip flop 136. When the output of the comparator is at Vin Voltage Level, the transistor sends a LOW signal to the clock of flip flop 136. The toggle of the output of comparator 134 acts then as a clock input, in order to produce a clean square wave at the line frequency (50 or 60 Hz) that toggles when the AC wave crosses zero volts, regardless of variations of the duty cycle of the dimmer and AC line voltage. The clean square signal is labeled as Zero Crossing and is inputted to the controller module 131, in order to control the timing of the dimming.

When dimming an incandescent bulb, the power supply 101c preferably works in a leading edge or forward phase control. In this mode, the controller module 131 receives the Zero Crossing signal and waits for a period of time, according to the dimming percentage value from the control module 102, before sending the ACTM1 signal to the high power module 132. ACTM1 signal is then continuously sent until the AC wave crosses zero and the cycle repeats.

When dimming an LED bulb, the power supply 101c generally works in a trailing edge or reverse phase control. In this mode, the controller module 131 receives the Zero Crossing signal to send a signal ACTM1 to the high power module 132 to turn on the lighting load 112. After waiting for a period of time calculated on the basis of the dimming percentage value, the sending of the ACTM1 signal is stopped. The drivers of most LED light bulbs usually consume a small amount of current which is not in sync with the frequency of the voltage of the AC mains 111. The current consumption of the LED light bulb is such that the current crosses zero several times during a 60 Hz cycle, usually reaching frequencies in the order of kHz. Therefore, when the sending of ACTM1 signal is stopped, shortly thereafter the current between the terminals of the TRIAC 115 will reach zero and will stop conducting due to the nature of the LED drivers. ACTM1 signal is not sent until the next zero crossing detection of the AC mains 111.

The current that flows out of the TRIAC 115 is labeled HPMCURRENT and is fed to the current sensing module 110. As described in previous embodiments, the current sensing module 110 converts the HPMCURRENT current into a voltage signal (Vout) to be fed to the ADC of the controller module 131. Vout is used to measure the power consumption, determine the type of technology of the lighting load connected (incandescent or LED bulb) to the power supply 101c, to determine the best mode of dimming a lighting load, i.e. leading or trailing edge, and to predict if the lighting load is going to fail soon.

The controller module 131 is also responsible for reading a voltage signal generated by the current sensing module 110, that indicates the current consumed by the lighting load 112. Said voltage signal may be communicated to the control module 102 for the user to monitor the power consumption.

### Second embodiment of the power supply for a smart dimmer

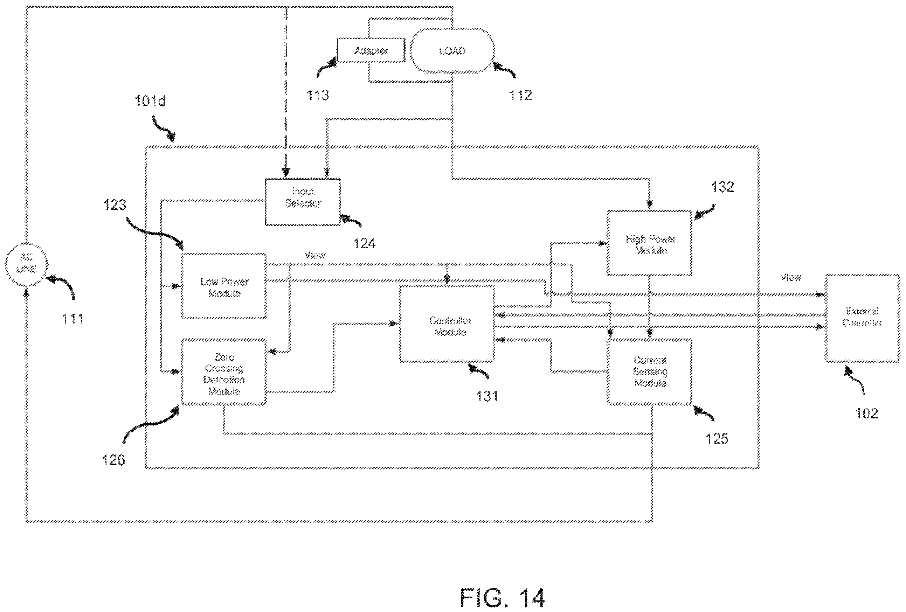

Now, referring to Fig. 14, the Power Supply 101d generally has six submodules: the low power module 123, that converts directly from AC to the second level DC voltage (Vlow), the input selector 124 for automatically selecting between the three-wire or the two-wire configurations, the high power module 109, the current sensing module 125, the controller module 131 and the zero crossing detection module 126, all of which are described in detail in the embodiments of the Power Supply 101a, 101b and 101c. The Power Supply 101d is also connected to lighting loads 112a, 112b, 112c and a low power lighting load adapter 113. An overall description of the embodiment is as follows.

The first mode of operation is implemented when there are three wires available in the switch box: phase wire, neutral wire and the lighting load wire, not taking into account the ground or earth wire. The wire from the lighting load 112, is connected to the input selector 124 and the high power module 132. The neutral wire is depicted in Fig. 14 as a dashed line. The wire from the lighting load 112 is connected to the input selector 124 and the high power module 132. When the lighting load 112 is in its off state, current will flow only through the input selector 124, since the high power module 132 will act as an open circuit. The input selector 124 leads to the low power module 123 that accesses the neutral wire needed to close the circuit via the lighting load 112, by letting a small current pass through the lighting load 112 and the Power Supply 101d itself.

If the lighting load 112 is a low power lighting load like a Light Emitting Diode (LED), the current flowing through the lighting load 112 and the Power Supply 101d may be enough to make the lighting load flicker, or it may be even that the impedance of the lighting load is low enough for it to illuminate. A single low power lighting load adapter 113 may be connected in parallel to the lighting load 112 to prevent these unwanted effects.

When the lighting load 112 is in its off state, a relatively small current flowing through the Power Supply 101d powers the low power module 123, which receives the powerfrom the AC mains 111 and outputs the constant second level DC voltage, Vlow. In this embodiment of the invention, all of the electronic components of the Power Supply 101d are galvanically isolated from the AC current from AC mains 111. The isolation in the low power module 123 is implemented by a flyback converter with a high voltage flyback switcher circuit and an isolated transformer, which outputs Vlow with its ground isolated from the AC mains 111.

Referring to Fig. 12 again, the activation signal ACTM1 is used to trigger the circuit that switches on or off the lighting load 112 in the high power module 132. In this module, the galvanic isolation is performed by means of opto-isolator 114 which receives the activation signal and lets current to flow into the gate of TRIAC 115 that is connected to the lighting load 112 and if the lighting load 112 is a low power lighting load, to the low power lighting load adapter 113 too. In response to the activation signal, the terminals of the TRIAC 115 act as a short circuit, allowing the AC mains 111 current to flow through the lighting load 112. The activation signal ACTM1 is provided by the controller module 131. The dimming of the lighting load 112 is performed in the same way as described in the embodiment for the Power Supply 101c.

When the lighting load 112 is switched on, the voltage drop on the same is almost of the same magnitude as the AC mains voltage 111. This causes a voltage divider effect that leaves almost no voltage in the low power module 123, causing a short circuit effect, thus leaving the Power Supply 101d with not enough voltage to operate. To overcome this issue, the controller module 131 receives a zero crossing signal of the voltage AC wave generated by the zero crossing detection module 126 and based on this signal, the controller module 131 waits for a period of time after the zero crossing detection to send the activation signal ACTM1. In this period of time when the lighting load is off, the low power module 123 receives enough power to operate until the next zero crossing. Consequently, the low power module 123 is always powered, regardless of the state of the lighting load 112.

The zero crossing detection module 126 is depicted in Fig. 9 and employs a bridge rectifier 127 connected to the AC voltage from the input selector 124 and the phase wire from the AC mains 111. The rectified AC signal is outputted to an opto-isolator or optocoupler 128 that galvanically isolates the zero crossing module from the AC mains 111. The output of the opto-isolator 128 is received by the base of the transistor 129. The transistor 129 then outputs a HIGH signal (Zero Crossing Signal) to the controller module 131 when the current in its base is zero, i.e., when the AC wave crosses zero, in order to control the timing of the turning on or off of the lighting load 112.

The HPMCURRENT that goes through the TRIAC 115 exits the high power module 132 and enters the current sensing module 125 for measuring the power consumption of the lighting load 112. A preferred embodiment of the current sensing module 125 is depicted in Fig. 10, which converts the current HPMCURRENT into a voltage signal (Vout) to be fed to the controller module 131. In this embodiment, the current sensing module 125 is galvanically isolated from the AC mains 111 with a device such as a hall effect sensor 130. The hall effect sensor 130 measures the HPMCURRENT 116 and outputs Vout which is sent to the controller module 131 in order to calculate the power consumption of the lighting load 112. Vout is also to determine the type of technology of the lighting load connected (incandescent or LED bulb) to the power supply 101d, to determine the best mode of dimming a lighting load, i.e. leading or trailing edge, and to predict if the lighting load is going to fail soon.

As discussed earlier, the smart switch device 100 corresponds to an ON/OFF switch 605 in a first embodiment. In a second embodiment, the smart switch device 100 can be: dimmer type or a remote switch type, among others 606.

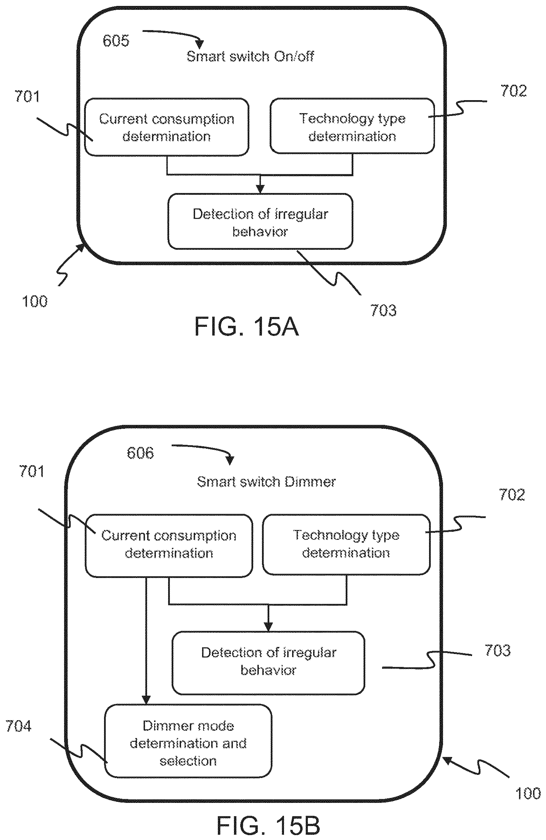

Fig. 15A depicts a smart switch device 100 which, in a preferred embodiment, is an ON/OFF switch 605 and comprises the functions of current consumption determination 701, technology type determination 702 and detection of irregular behavior in the operation 703 of a lighting device connected thereto. In another preferred embodiment, the smart switch device 100 may be a dimmer type switch 606 as depicted in Fig. 15B, comprising the functions of current consumption determination 701, technology type determination 702 and detection of irregular behavior in operation 703 of a lighting device connected thereto; it also includes the dimming mode determination and selection function 704.

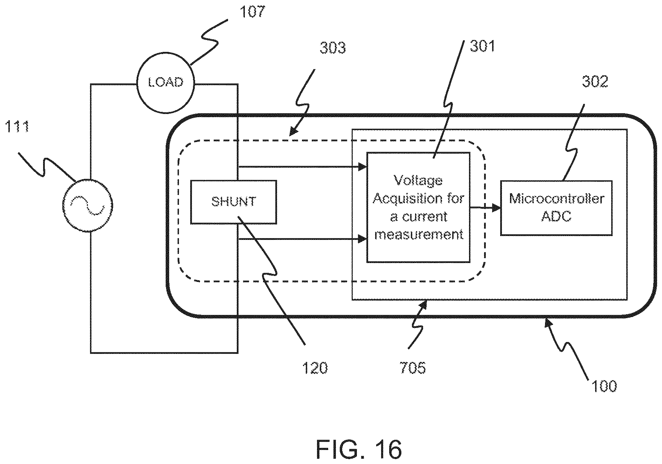

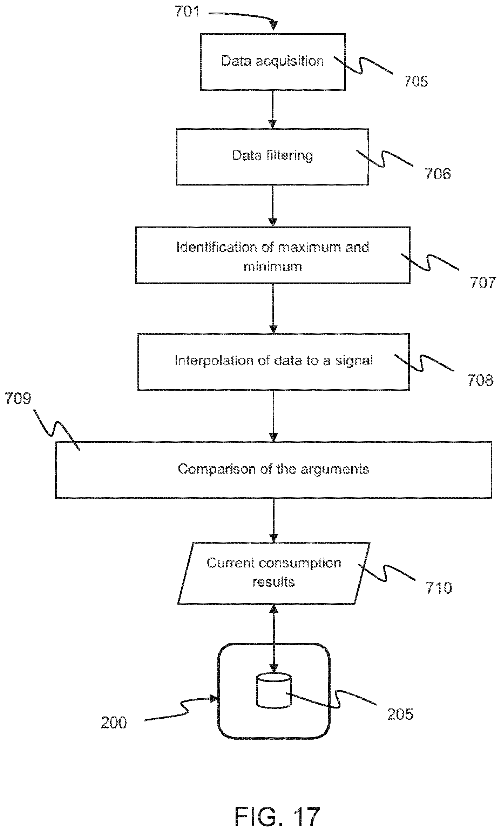

Fig. 17 depicts, in a preferred embodiment, a flowchart of a function for determining the current consumption 701 of the lighting device 112 connected to the smart switch device 100, said function 701 being performed by the controller module 102 when the smart switch device 100 is in an ON state and the components are in series, for example, as shown in Fig. 16.

The function 701 is performed each time that the central control system 200 requests it. In a preferred embodiment, said function 701 is initiated in step 705, for example, after the smart switch device 100 is turned ON, the current begins to flow through the lighting device 112 and the components of the smart switch device 100.

In step 705, the instant current consumption samples of the lighting device 112 are acquired and processed, the instant current consumption sampling being performed by each line 105 of the smart switch device 100. Once the analog voltage signal (Vout) has been conditioned, said analog voltage signal Vout enters the ADC 302 so that it becomes a digital voltage signal. In this step 705, a number of n samples of values of the voltage signal representing the instant current are taken, for example, in a preferred embodiment, for each wave cycle of the current signal, an approximate of 256 samples is recorded per wave cycle or a total of 800 samples in a given period of time or depending on the number of samples that are required by the function. The voltage signal samples are taken during a certain period of time. In a preferred embodiment, the time period comprises a range of 1 to 83 µs (1 mHz to 12 kHz).

The data of the samples obtained from Vout represent the current consumed by the lighting device 112, and are stored in an array of variables in a stored data matrix, for example, inside a memory of the control module 102 of the smart switch device 100 to facilitate their treatment and processing.

In step 706, a data processing operation is applied to Vout of the samples obtained in step 705. By way of detail, in a preferred embodiment, an amplitude filtering is applied to eliminate the noise in the signal of voltage due to the noise existing in the AC source 111, known as a Noise Reduction Filter, NRF filter. Since small variations or small voltage peaks are possible in the voltage curve, they can be eliminated or ignored so that they do not affect the analysis of the signal. Therefore, in a preferred embodiment, an amplitude filter is applied to eliminate said peaks, which generally results in an average of said peaks lying on the voltage curve, in order to correct and smooth the voltage signal.

The filtering of data also involves applying a Magnitude Filtering, MF filter, wherein the signals of low amplitude are eliminated. The filtering of data further comprises applying a frequency filter, in a preferred embodiment, an N order Finite Impulse Response, FIR of 128^{th} order filter is applied. For example, in the N order FIR, signals of high frequency are filtered. Subsequently, the filtered voltage signals samples are converted to a current signal according to the proportional voltage and current ratio, so as to represent the samples in a current consumption signal of the lighting device 112.

In step 707, once the voltage signal converted into the current signal of the lighting device 112 is received, the control module 102 performs a methodology for identifying the max and min current consumptions of the lighting device 112.

In step 708, a polynomial interpolation method is applied to attenuate the current signal due to the set of discrete data found in the current signal. By way of example, a general Newton polynomial is used, or, in a secondary embodiment, any other known interpolation method may be used.

In step 709, some features of the current signal are determined for use in performing the functions of the method; in a preferred embodiment, the standard deviation of the current samples is obtained. On the other hand, in another preferred embodiment, the average of the attenuated current signal is calculated to obtain a Root Mean Square, RMS, of the consumed current of the lighting device 112 in order to correctly estimate the current consumption. For the calculation of the RMS, since the current signal can be expressed as a continuous variable function then a set of *n* variable values is registered, therefore, the RMS, or the effective value of the current signal can be obtained.

Continuing with step 709, a comparison is made between the data obtained from the previous steps. For example, in a preferred embodiment, the current signal is compared to the time, AC voltage, HPMCURRENT 116, among other possible variants of comparison or of measurable parameters for a thorough analysis of the current consumption. Additionally, it is worth mentioning that each of the signals for each lighting device 112 are excluded from a calculation of power consumption based on the variance obtained from the statistical methods mentioned above.

At the end of step 709, after all the comparisons have been made, a result 710 of comparison of the current samples with respect to the time of the current consumption for each line 105 of the smart switch 100 is obtained.

An additional process is performed to the final result 710. In an experimental calibration carried out previously, current consumption models of the existing lighting devices are obtained according to the different types of lighting technologies, which are tested in factory conditions, said consumption models obtained are stored on a database 205 within a memory 204 of the central control system 200. In said process the current consumption results 710 of the lighting device 112 are verified with the current consumption models of the database and, thus, the RMS current is estimated more accurately.

The final result of the current consumption is stored in the database 205 of the central control system 200 by means of a record to be used in subsequent calculations required by the central control system 200.

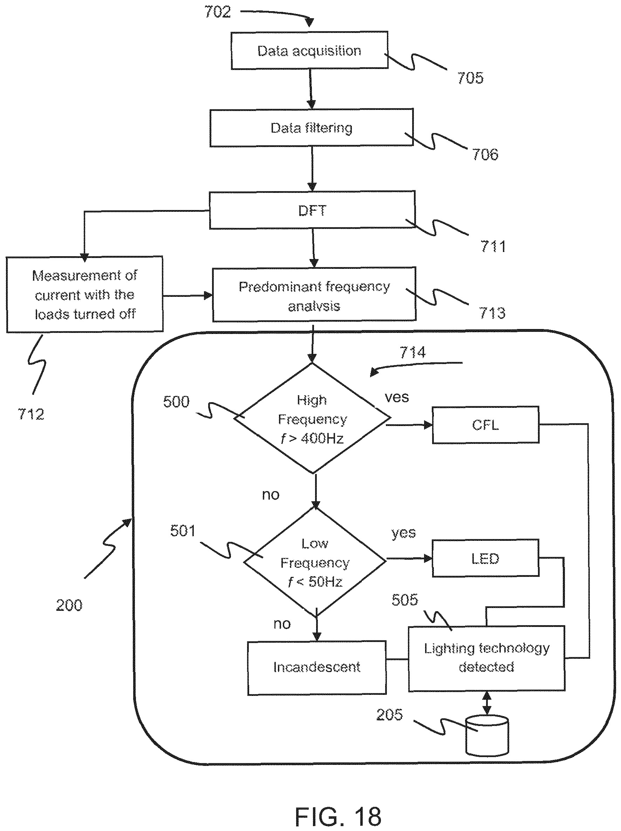

Referring to Fig. 18, a flowchart of a function for determining the type of technology of the lighting device 702 connected to the smart switch device 100 is shown in a preferred embodiment, said function being also performed by the control module 102. The function 702 is performed each time that the central control system 200 requests it. This function 702 performs the same procedure of step 705 described above; however, in this function 702 the number of samples taken that can be n number of samples is changed, or in a preferred embodiment, about 1 million samples can be taken to perform the function 702 for determining the technology type of the lighting device. In a preferred embodiment, by obtaining in this step 705 the digital voltage samples representing the instant current consumed by the lighting device 112, said samples may or may not be stored in the memory204 of the central control system 200 due to the amount of data obtained.

With the voltage samples obtained from step 705 a data filtering similar to the procedure of step 706 is applied. In a preferred embodiment, the filtering of data may be performed with an amplitude filtering to eliminate the noise in the voltage signal due to the noise existing in the AC source 111, the applied filter being determined as a Noise Reduction Filter, NRF filter. Furthermore, the data filtering comprises, in a preferred embodiment, applying a Magnitude Filtering, MF filter to ignore or eliminate the low amplitude frequencies or harmonics related to the noise in the voltage signal and also comprises a frequency filtering, which can be a Finite Impulse Response, FIR filter similar to the FIR of step 706. In general, this filtering is applied to the voltage samples to eliminate very small voltage changes, very high frequencies and/or noise with frequencies greater than 5 kHz to let only the desired or objective signal pass.

Because each type of lighting device technology consumes current at different relevant frequencies, which range from 10Hz for LED-type lighting devices to 4.7 kHz for CFL-type lighting devices, it is necessary to perform a frequency analysis. In addition to the frequency analysis, it is worth to mention that for determining the type of technology, it is necessary to know the duty cycle of the current consumption of the lighting device 112, since each type of technology can vary its current consumption in different duty cycles. For example, in some lighting device technologies, the cycle of the current consumption signal may be less than one cycle of the AC power supply wave, or in other cases there may be between an approximate range of 5 to 10 cycles of the wave compared to the AC power supply, or duty cycles may vary depending on the lighting device according to the manufacturer.

Therefore, in step 711, the control module 102 performs a digital processing method to obtain the current consumption behavior in the frequency of the lighting device 112, wherein the filtered voltage signal is treated with a digital processing, that is, in a preferred embodiment, a Discrete Fourier Transform, DFT, is performed to the filtered voltage signal wherein the samples of voltage signals taken in the time domain are transformed or converted into the frequency domain. Therefore, a frequency (Hz) and amplitude in decibels (dBm) ratio of the voltage signal samples is obtained.

In a parallel step 712 that is performed in a very small period of time imperceptible to the user, the microprocessor also executes a process to calculate only the current consumption of the power supply 101 of the smart switch device 100 with the lighting devices turned OFF, wherein the process in which the current consumption data of the power supply 101 of the smart switch device 100 is obtained by performing steps 705, 706 and 711. These data of the current consumption of the power supply 101 are also transformed to the frequency domain to discard said information in the frequency analysis 713.

Subsequently, with the parameters of frequency (Hz) and amplitude in decibels (dBm) obtained in steps 711 and 712, the predominant frequencies of the current consumption of the lighting device 112 are analyzed. That is, the less relevant frequencies are filtered (such as 6 dBm) with respect to the maximum frequency and the frequencies obtained from the power supply 101 are differentiated to have only the frequencies of the lighting device 112.

Once the predominant frequencies have been analyzed, the type of technology of the lighting device 112 that is connected to the smart switch device 100 is determined in step 714, which is carried out when comparing the frequency results and the periodic pattern of the current signal (duty cycle) with the different types of lighting devices 107 existing.

A comparison is performed in step 714, which is performed in the central control system 200, wherein the results obtained from the frequency current signal are compared with a frequency data model stored in the memory 204 of database 205. The database 205 contains the model with frequency data measured and analyzed from an experimental calibration previously made of the different types of lighting device technologies, tested in factory conditions where the data is conditioned and stored in the database 205 to be read when needed. In the comparison 714, the phase shift (duty cycle) pattern of the current consumption frequencies of the lighting device 112 is also compared to the frequency of the AC power supply 111, thereby determining what type of lighting device 112 is connected. For example, in a condition 500 wherein if the current consumption frequency of the lighting device 112 is greater than 400Hz it is determined that the type of technology of the lighting device is Compact Fluorescent Light, CFL. In another condition 501, for example, if the current consumption frequency of the lighting device 112 is less than 50Hz it is determined that the technology of the lighting device is Light-Emitting Diode, LED or in the case that the frequency of the current consumption of the lighting device 112 does not meet any of the conditions 500 and 501 that means that the frequency is equal to that of the AC mains 111 and, therefore, it is determined that the lighting device 112 is of the incandescent or resistive type, this result 505 is further verified with the stored frequency model of the database 205. Subsequently, this verified information is stored in the database 205 of the central control system 200 for its registration or subsequent calculations.

An important parameter is the real power 715 consumed by the lighting device 112 of the smart switch device 100, such parameter is informed to the central control system 200 and an end user. For this purpose, the method allows estimating the effective power 715 of the lighting device 112 from the results obtained by the functions of: determination of current consumption 710 and determination of technology type 702 of the lighting device 112. First, in database 205, information in power percentages and quality factors is stored according to the type of lighting device technology. Said information, in a preferred embodiment, is conditioned by using Taylor polynomials, wherein information is evaluated to determine what amount of active and reactive power is consumed depending on the type of lighting device 112.

The central control system 200 performs an evaluation with the information stored in the database 205, that is, with the percentages of power and quality factors for the different types of technology, together with the result of the current consumption 710 and the identification of technology type 702 of the lighting device 112 connected, the percentage of active power and the percentage of reactive or imaginary power are calculated to obtain the actual power 715 of the lighting device 112. This information is stored in the database 205 of the central module 200 for a record or subsequent calculations required by the central control system 200.

The lighting devices 107 change their operational behavior with frequent use overtime, due to the deterioration of their components or materials. The deterioration of the lighting devices 107 is mainly observed in current consumption or changes in the frequency, that is, a less uniform behavior in the current consumption frequency. Forthis, it is necessary to detect irregular behaviors in the operation of a lighting device 112, in order to avoid a high energy consumption or to provide an alert to replace the lighting devices before a failure occurs.

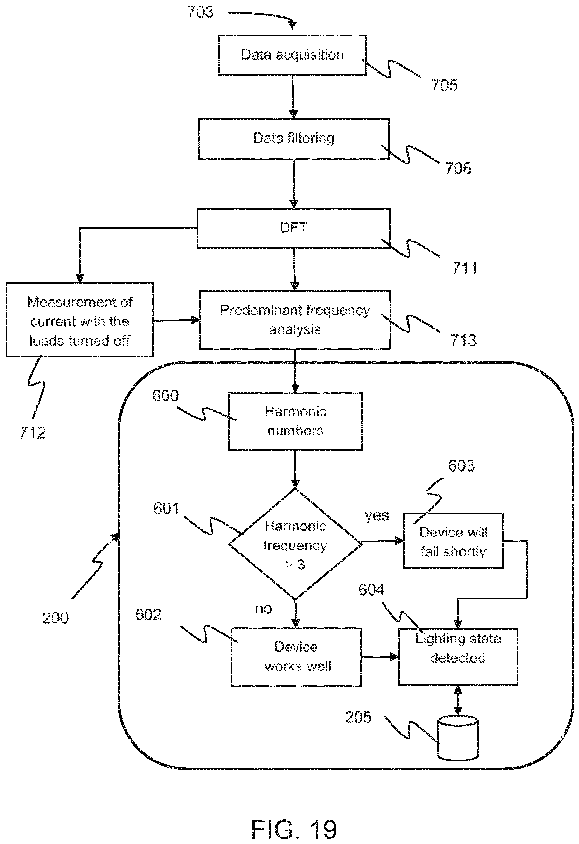

Fig. 19 depicts a flowchart of a function 703 for detecting irregular behavior in the operation of a lighting device 112 connected to the smart switch device 100. This function 703 is performed by the control module 102, and the function 703 which is performed each time the central control system 200 requests it.

The function 703 performs the same steps 705, 706, 711, 712, 713 as the function 702 to obtain the frequency data that represents the consumed current of the lighting device 112. The function 703 executes a harmonic frequency analysis 600, performed within the central control system 200, then a calculation is executed to detect a certain amount of maximum values of relevant harmonic frequencies 600 of the current consumption of the lighting device 112. A condition 601 for a first case is met if the maximum number of detected harmonics is greater than 3, then it is determined that the lighting device 112 will fail within a close period of time, such condition is depicted in result 603. The function 703 additionally determines if there is an increase in the current consumption of the lighting device 112 by means of the comparison of what was initially recorded with the data obtained from the experimental model of current consumption, so that, it can be determined the existence of perturbations in the lighting device 112. Otherwise, in a second case, condition 601, if the number is not greater than 3, it is reported that the lighting device 112 continues operating correctly, which is depicted in result 602. The outcome of the cases is stored in the result 604 and further stored in the database 205 of the central control system 200for recording or subsequent calculations.

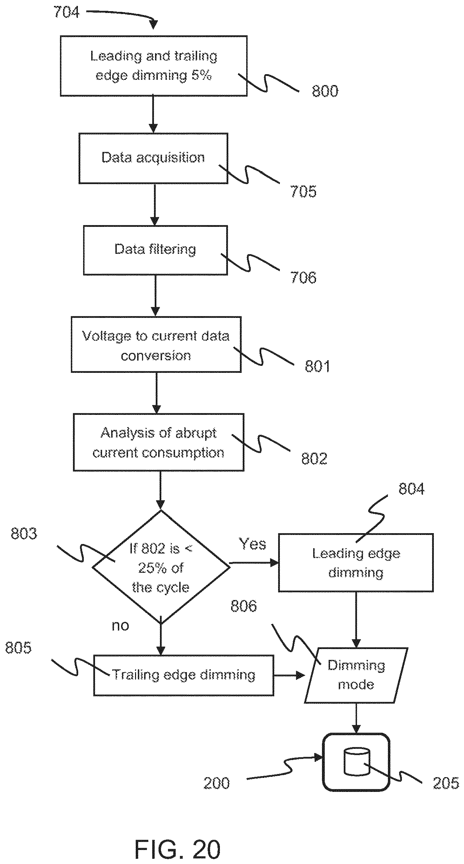

Fig. 20 depicts a flowchart of a function for determining and selecting the most appropriate dimming mode, depending on the type of technology of the lighting device 112 connected to the smart switch device 100. This function is implemented since there is a large variety of lighting technologies, which respond to a specific dimming mode, depending on the configuration of the internal electronics used by the manufacturer of the lighting device. The above mentioned is due to the fact that, by inappropriately dimming a lighting device, they may exhibit unusual behaviors, such as flickering thereof, increase in the consumption of electrical power and/or reduction of the life period of the lighting device.

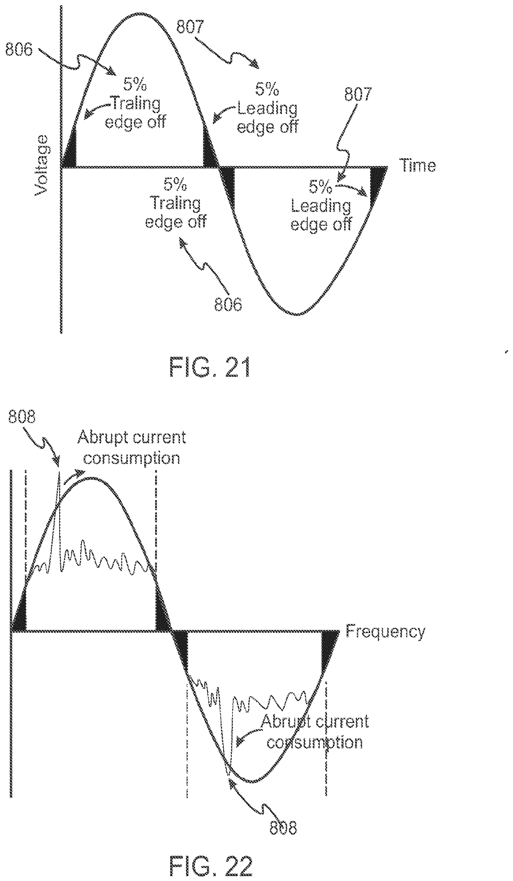

The function 704 determines and selects the dimming mode and is executed by the control module 102 and is performed whenever the central module 200 requests it. The function 704 starts at a step 800, where the lighting device 112 is dimmed, in a preferred embodiment depicted in Fig. 21, the lighting device 112 is turned off at the 5% of the wave cycle at the start 806 and at the end of the wave 807 both in the positive and the negative curve of the AC power wave. These dimming modes are commonly named trailing 806 and leading 807 edge, in this function 704 both dimming modes are applied in the same sine wave, that is, they are simultaneously applied in the same wave cycle.

After executing step 800, an analysis of the obtained signal is carried out to observe the current behavior of the lighting device 112. Therefore steps 705 and 706 are performed as above mentioned in the previous functions, that is, a data acquisition of the current consumption is obtained during a determined period of time similar to that of function 701. Then the step 706 is performed, which performs a filtering of data corresponding to a n number of samples of values of the voltage signal obtained. In step 801 the filtered voltage samples are converted to current consumption samples of the lighting device 112. In a subsequent step 802, the current consumption samples are analyzed to identify and determine the most abrupt current consumption 808 in the AC wave cycle caused by the 5% trailing and leading edge dimming performed in step 800. In this same step, in addition to determining the most abrupt current consumption 808, the location of the maximum current consumption within the AC wave cycle is also determined.

In step 803, the dimming mode is selected in a conditional selection depending on the result obtained in step 802. In a first case, if the most abrupt current consumption 808 is located before a 25% of the AC wave cycle (50% of a half wave), for example, as shown in Fig. 22, the most suitable dimming mode for not damaging the lighting device 112 is selected as a leading edge type dimming mode 804. This abrupt current consumption 808 occurs due to the trailing edge dimming mode that was applied in step 800, said abrupt current consumption 808 is due to the lighting device 112 not responding or operating properly with the dimming mode applied at 5% (trailing edge), due to the configuration of the internal electronics of the lighting device 112 that was designed by the manufacturer and which responds to a specific dimming mode. Therefore, a suitable manner to dimming the lighting device is in leading edge mode.

In another example, in a second case, with the condition of step 803, if the most abrupt current consumption is located after 25% of the wave cycle of the AC wave (50% of a half wave), in a preferred embodiment, the appropriate dimming mode corresponds to a trailing edge mode, since the abrupt current consumption is caused by the leading edge dimming mode, said maximum current consumption is due to the lighting device 112 not responding or operating properly with the dimming mode applied 800, due to the configuration of the internal electronics of the lighting device 112 that was designed by the manufacturer and which responds to a specific dimming mode.

Once the appropriate dimming mode 804 or 805 has been determined and selected for the lighting device 112, said result is stored and sent to the database 205 of the central control system 200, so that the selected dimming mode is specifically set for the lighting device or until the lighting device 112 is replaced or the central control system 200 again requests performing the function to determine or select the dimming mode, or when a user needs to request said function.

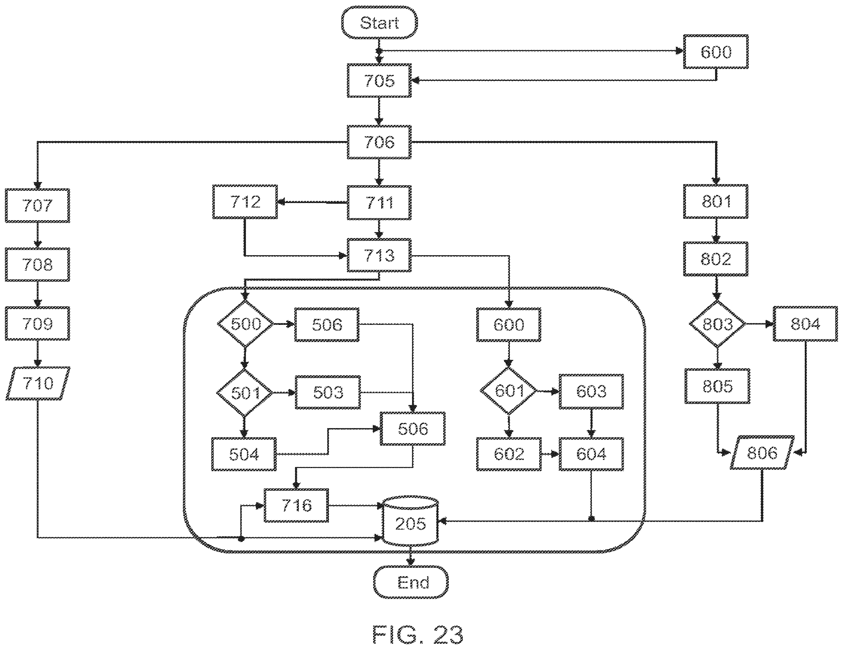

Fig. 23 shows the method for analyzing operating parameters for lighting technologies of a smart switch device. As can be seen in the description in each of the functions, there are common steps that are performed once for the different functions using them in the method, as can be seen in Fig. 23, wherein the step 705 which is shared by all functions that acquires the data through sampling which passes through a filter at step 706, wherein at the end of functions 701 and 702 the result of the current consumption of step 710 and the type of technology detected from step 505 are used to obtain the power consumption in step 715 which is performed by the central module 200 and the results are sent to database 205. Functions 702 and 703 of the method share steps 711, 712 and 713 which perform the technology type determination and the determination irregular behavior whose results are sent to the database 205 of the central module 200 as described above. Function 704 likewise uses the data acquisition of step 705 and data filtering of step 706, wherein the result obtained by the function 704 corresponds to the dimming mode for the connected lighting device and wherein said result is also sent to the database 205 of the central module 200.

### Central control system

Now the central control 200 will be described in detail. Referring to Fig. 3 again, the central control system 200 is shown in a preferred embodiment, which allows to configure and control at least one or more intelligent switch devices 100 of an electrical installation. The central control system 200 at issue comprises a central communications module 201, which allows communication with the communications module 104 of said at least one or more intelligent switching devices 100; a TCP/IP communications module 202, which allows to send data to an external server or cloud, wherein the TCP/IP communications module 202 may be a wireless and/or wired connection module; a web services module 206; a messaging services module 207; a process register module 208; a processor 203 and a memory 204 coupled to the processor 203. The processor 203 is configured to create a local database 205 in the memory 204 for storing the data generated by said at least one or more intelligent switching devices 100, via a remote user interface 500 and by the data generated by said central control system 200. Likewise, the local database 205 stores the commands for performing the functions of said at least one or more intelligent switching devices 100 sent from the remote user interface 500.

The processor 203 is also configured to perform the configuration of the central communications module 201 so that it can establish a communications network between said at least one or more intelligent switching devices 100 via the communications module 104 thereof; establishing a communications network comprises the following steps:
STEP 1: initially configure the central communications module 201 based on preset parameters and thereafter, send an information request query to said at least one or more intelligent switch devices 100 which are in a first path, and send one broadcast signal to indicate that the central communications module 201 enters and remains in a standby state for a set time.
STEP 2: receiving, while in said standby state, a signal with the required information from said at least one or more intelligent switch devices 100 forming part of the electrical installation.

Referring to STEPS 1 and 2, the central control system 200 sends a broadcast signal to all the communication modules 104 of the intelligent switch devices 100 which are in a first path, the first path being determined by the signal strength between the communication modules 104 of the intelligent switch devices 100 and the central communications module 201 of the central control system 200; this in order to indicate to the communication modules 104 of the intelligent switch devices 100 that the central communications module 201 enters a standby mode and will remain in this state for a certain time. Likewise, an information request query is sent to the intelligent switch devices 100 in order for them to send back a signal with the required information, said information including a unique address, MAC address and signal strength. In a preferred embodiment, the preset parameters for the initial configuration include at least one of a frequency, a central communications module 201 ID, a network ID, an encryption for communications and the power output.

STEP 3: allocating an ID to each of said at least one or more intelligent switch devices 100 based on the required information of each of said at least one or more intelligent switch devices 100, wherein each ID is stored in said local database 205 to create an ID table, and thereafter sending said ID to said at least one or more intelligent switch devices 100.

Regarding STEP 3, once the requested information is received, the central control system 200 allocates an ID to all intelligent switch devices 100 of the first path. The ID comprises an ID credential of the smart switch device 100 followed by its MAC address (a single ID register) and signal strength, which are stored in the local database 205 to create an ID table; said ID is sent back to the intelligent switch devices 100 so that they recognize their ID credential allocated by the central control system 200. The ID table is comprised of at least the IDs of the intelligent switch devices 100 of the first path.

STEP 4: Initiating a discovery step, wherein the discovery step comprises the following steps:
sending from each of the intelligent switch devices 100, a broadcast signal to all the communication modules 104 of the intelligent switch devices 100 which are in the first already established path;
sending from each of the intelligent switch devices 100, an information request query to the intelligent switch devices 100 which are in the first already established path in order for them to send back a signal with the required information, said information including a unique address, MAC address (single ID register) and signal strength; and
forwarding, from each of the intelligent switch devices 100, the signal with the required information of each of the intelligent switch devices 100 to the central control system 200.

With respect to STEP 4: once the ID table with the IDs of intelligent switch devices 100 is created, the central control system 200 initiates a discovery step, in which, in the first instance, each of the intelligent switching devices 100 sends a broadcast signal to all the communication modules 104 of the intelligent switch devices 100 which are in the first already established path. Thereafter, each of the intelligent switch devices 100 sends an information request query to the intelligent switch devices 100 located in the first already established path in order for them to send back a signal with the required information, said information including a unique address, MAC address and signal strength. Finally, each device forwards the signal with the required information from each of the intelligent switch devices 100 to the central control system 200.

That is, each of the intelligent switch devices 100 performs a discovery of other intelligent switch devices 100 that are found around them within the first path and receive and send information from said other intelligent switch devices 100 that are around them to the central control system 200. In performing this discovery step, the central control system 200 is able to know the information of intelligent switch devices 100 outside its range within the first established path.

STEP 5: allocating an ID to each of the intelligent switch devices 100 outside the range of the central communications module 201 of the central control system 200 based on the required information of the intelligent switch devices 100 that are outside the range of the central communications module 201 of the central control system 200, wherein each ID is stored in said local database 205 to update the ID table, and thereafter sending each of the IDs to the intelligent switch devices 100 outside the range of the central communications module 201 of the central control system 200.

The central control system 200 repeats the above steps for each smart switch device 100 and thereby can establish the communication network as a whole. In addition, the ID table is also comprised of the IDs of intelligent switch devices 100 of different paths.

STEP 6: establishing, through the smart switch device 100 closest to the central control system 200, the optimal path through which the information between the central communications module 201 and the communication modules 104 of the intelligent switch devices 100 that are in the communication network is sent and received.

With regard to STEP 6, the most optimal path is determined by the signal strength and the number of hops per path (n) between the communication modules 104 of the intelligent switching devices 100 and the total number of paths (m). These optimal paths, comprised by n and m, (n,m) are called dynamic tensors.

STEP 7: generating a dynamic routing table with each ID allocated to each of said at least one or more intelligent switch devices 100 and the optimal paths set in STEP 6, wherein said dynamic routing table is stored in said local database 205.

With respect to STEP 7, once the communication network is completely established, a dynamic routing table is generated with each ID of said at least one or more intelligent switching devices 100 and with the optimal paths.

When an additional smart switch device 100 is added to the electrical installation, the communication network is updated, upon receiving a request from the user, and an updated dynamic routing table is generated.

Significantly, when an smart switch device 100 is removed from the electrical installation, the communication network is updated upon receiving a request from the user, and an updated dynamic routing table is generated.

Accordingly, when a command is received from a user to remove an smart switch device 100 from the communication network, a new dynamic routing table is generated.

With each of the aforementioned steps, the central control system 200 allows to initially configure the central communications module 201 to subsequently establish a communication network with at least one or more intelligent switch devices 100, wherein the communication network created is a mesh, preferably a Point-to-Multipoint Meshed-type communication network, in which routing rules are determined which allow optimizing the communication between the central control system 200 and said at least one or more intelligent switch devices 100. In order to optimize the communication, as described in STEP 7, a dynamic routing table is generated by the required information and optimal paths of said at least one or more intelligent switch devices 100, said required information comprising the following data: MAC address and signal strength. The optimal paths are determined by the number of hops per path (n) between the communication modules 104 of the intelligent switching devices 100 and the total number of paths (m); these optimal paths, comprised by n and m, (n,m) are called dynamic tensors. The routing table determines the optimal paths for communication between the communication modules 104 of the intelligent switch devices 100 and the central communications module 201 of the central control system 200.

When the communications module 104 of an smart switch device 100 is outside the range of the central communications module 201 of the central control system 200, the communications module 104 of another smart switch device 100, which is within the range of the central communications module 201, works as a repeater of the information sent from the smart switch device 100 outside the range of the central communications module 201 of the central control system 200. An optimum path is defined through the dynamic routing table for communication between the central communications module 201 and the communications module 104 of the smart switch device 100 outside the range of the central communications module 201, through the communication modules 104 of one or more smart switch devices 100 that are within the range of the central communications module 201. By optimizing the communication with the dynamic routing table and the capacity of the intelligent switching devices 100, it is possible to obtain a broader range of network coverage.

In addition, in a secondary embodiment, the routing table, apart from determining the optimal communication paths, is able to determine alternative paths between the communication modules 104 of the intelligent switching devices 100 and the central communications module 201 of the central control system 200, in case communication cannot be performed through the optimal paths.

The web services module 206 enables the implementation of all services performed from the remote user interface 500 in the central control system 200. In a preferred embodiment, the web services module 206 is structured in hierarchical layers. The web services module 206 consists of the following functions:
- Create user account: the user enters, from the remote user interface 500, a set of data necessary to create an account.
- Query user name: is responsible for querying if a user name exists, since the username field has a unique index, it is possible to repeat the user name.
- Activate user account: is responsible for changing the status of a user account from inactive to active.
- Register Mail: is responsible for registering an email of a user.
- Request user account recovery code: is responsible for generating and sending a user account recovery code to the email entered by the user.
- Update password by recovery code: is responsible for updating a user's password in case the recovery code entered by the user is correct.
- Query data from a user account: it takes care of obtaining the data of an account of a specific user.
- Update data from a user account: is responsible for updating the data of a specific user account.
- Request a phone update: is responsible for creating a code that validates the entry of a new phone number and sending said code to the new phone number.
- Validate a phone update code: is responsible for comparing the code sent to the new phone number and a code entered by the user. If both codes are the same, the new phone number is updated.
- Request an email update: is responsible for creating a code that validates the entry of a new email and sending said code to the new email.
- Validate an email update code: is responsible for comparing the code sent to the new email and a code entered by the user. If both codes are the same, the new email is updated.
- Update a user's password: is responsible for updating a user's password. First, the current password is compared to the password entered by the user. If both passwords are the same, the new password is updated.
- Login: is responsible for authenticating a user to access the functions of the smart switch device 100.
- Logout: is responsible for deleting the data created during a user session.
- Associate a central control system 200 with a user account: is responsible for entering data related to a central control system 200 and performing an association of the data related to a central control system 200 with the user's account.
- Display a list of central control systems: is responsible for displaying a list of data related to each of the central control systems that a user has access to.
- Query data of a central control system 200: is responsible for obtaining the data related to a central control system 200.
- Delete data of a central control system 200: is responsible for deleting data related to a central control system 200.

In a preferred embodiment, the data relating to a central control system 200 comprises at least one user, intelligent switch devices 100, a history and functions of the intelligent switches.
- Rename a central control system 200: is responsible for changing the current name of the central control system 200 to a new name.
- Switch on all intelligent switch devices 100: is responsible for powering the lines 105 to turn on all the intelligent switch devices 100 associated with a central control system 200.
- Create an smart switch device 100: is responsible for adding an smart switch device 100 to a central control system 200 and to make an association of said intelligent switching device 100 to a user.
- Querying data of an smart switch device 100: is responsible for obtaining the data related to an smart switch device 100. Said data relating to an smart switch device 100 consists of at least one name and icon.
- Update data of an smart switch device 100: is responsible for updating the data related to an smart switch device 100. Said data relating to an smart switch device 100 consist of at least one name and icon.
- Delete one or more intelligent switch devices 100: is responsible for deleting one or more intelligent switch devices 100 associated with a user and a central control system 200, wherein data relating to said one or more intelligent switch devices 100 is deleted.
- Switch on all the central control systems 200: is in charge of turning on all the central control systems 200, which in turn power the lines 105 to turn on all intelligent switch devices 100 associated with said central control systems 200, wherein these are associated with a user.
- Update the order of the central control systems 200: is in charge of updating the positions of the central control systems 200 and/or intelligent switch devices 100 associated with said central control systems 200.
- Change the state of a function of an smart switch device 100: is responsible for changing the state of an smart switch device 100, wherein the states consist of at least on, off and intensity.
- Rename all central control systems 200: is responsible for renaming all central control systems 200 and all intelligent control devices 100 associated with said central control systems 200.
- Display a list of favorites: displays a list of favorites of the central control systems 200 and/or intelligent switch devices 100 and/or lines 105 associated with said central control systems 200 of a user.
- Add a central control system 200 and/or an smart switch device 100 and/or lines 105 to favorites: is responsible for entering a central control system 200 and/or an smart switch device 100 and/or lines 105 to a list of a user's favorites.
- Delete a central control system 200 and/or an smart switch device 100 and/or lines 105 from favorites: deleting data from a central control system 200 and/or an smart switch device 100 and/or lines 105 from a user's list.
- Update the order of a list of favorites: is responsible for updating the positions of the central control systems 200 and the intelligent switching devices 100 and/or lines 105 associated with said central control systems 200 that are added to the favorites list.
- Add a user: is responsible for adding new users to a central control system 200.
- Display a list of users: is responsible for displaying a list of users added to a central control system 200.
- Query a user's data 200: is responsible for obtaining the user data related to a central control system 200.
- Update a user: is responsible for updating the data of a user related to a central control system 200.
- Block a user: is responsible for blocking users related to a central control system 200.
- Delete a user: is responsible for deleting data of users related to a central control system 200.
- Check history: is responsible for displaying the last 10 events. The remote user interface 500 displays the last 10 events or events are displayed by date range.
- Record in history: is responsible for registering different events that originate in the remote user interface 500.
- Check image gallery: is responsible for displaying and sending the different url of the image gallery.
- Enter a routine: is responsible for adding a register corresponding to a routine. In a preferred embodiment, a routine is defined as a set of programmed actions that the user can specify in the remote user interface 500.
- Check list of routines: is responsible for showing the routines of a user.
- Query data from a routine: is responsible for obtaining the data of a routine entered by a user.
- Update a routine: is responsible for updating the data of a routine of a user.
- Change routine status: is responsible for updating the status of a routine of a user.
- Delete a routine: is responsible for deleting the data of a routine of a user.
- Obtain report of energy consumption: is responsible for generating a report with graphs of electricity consumption.
- Update payment method data: is responsible for updating the payment method of a service user.
- Update type of membership: is responsible for updating the type of a user membership.
- Get invoice of the month: is responsible for generating the invoice of a specific month for a user.
- Enable Sleep Mode: is in charge of enabling Sleep Mode of an smart switch device 100. The Sleep Mode allows to disable the LEDs and touch interface of an smart switch device 100.
- Lock an smart switch device 100: is responsible for locking the user interface 103. That is, locking all functions related to the smart switch device 100 manually and/or remotely.
- Switching on a set of intelligent switch devices 100: is responsible for switching on a set of intelligent switch devices 100 associated with a central control system 200.
- Manage a set of intelligent switch devices 100: is responsible for activating, removing, updating and consulting a set of intelligent switch devices 100 associated with a central control system 200.

In a preferred embodiment, upon activation of a first user account, the user is designated as a manager. The manager user, from the remote user interface 500, can perform all the functions mentioned above and, likewise, can manage users with different hierarchies. The manager user, when using the Add User function, can create different profiles of users with different characteristics: co-manager user, which has access to all the functions of the manager user except the delete manager user function; secondary user, which has access to partial or total functions depending on the permissions granted by the manager user; and guest user, which has access to partial or total functions for a certain time depending on the permissions granted by the manager user.

Generally, the remote user interface 500 can be integrated and interact with different Internet of things (IoT) platforms, such as Amazon Echo, Apple HomeKit, IFTTT, Nest, Smart Things, Google Home, among others.

Importantly, in case of no internet connection, the central control system 200 acts as a local server for the intelligent switch devices 100.

In a preferred embodiment, the processor 203 is configured to provide a variety of processes for the operation of the central control system 200, which are:
- Data backup process, in which the central control system 200 has one hour set to back up the data. The time set for performing the data backup is verified, if the time is correct, the process is initialized which comprises reading data that is stored in the local database 205 and subsequently creating a backup file. The backup file is named and compressed in a ZIP-format with password, which is stored in the local database 205. Once the backup file is created, named and compressed, the central control system 200 checks if there is Internet connectivity, if the central control system 200 confirms internet connectivity, the backup file is sent to the cloud. In addition, the process register module 208 creates a register of the data backup process. Said register, in a preferred embodiment, comprises data backup process start date and time, data backup process end date and time, success or failure of the data backup process, and success or failure of sending the backup file to the cloud.
- Factory reset process, which is initialized via the remote user interface 500 and manually by pressing a physical button coupled to the central control system 200. When the user, through the remote user interface 500, sends a factory reset request to the central control system 200, which is received by the messaging service module 207, it is reported via the TCP/IP communications module 202 to the cloud and through a router to the local database 205, that the factory reset process has begun. Subsequently, the factory services are reset and the cloud is queried through the web services module 206 if there is a program change, firmware. In case there is a program change, firmware, the new existing program is downloaded and all essential programs of the central control system 200 are updated.
- Restore process, which is initialized via the remote user interface 500 when submitting a restore request. From the remote user interface 500, the user selects the backup of a list comprising data stored in the local database 205, once the data to be restored is selected, the restore request is sent to the central control system 200, which is received by the messaging services module 207. Upon receipt of the restore request, it is confirmed whether the backup of the list selected by the user is stored in the cloud; in case of confirming that the backup of the list selected by the user is stored in the cloud, the restoration of the central control system 200 is made. Once the restoration of the central control system 200 has been completed, the backup of the list selected by the user is acquired from the cloud and is input to the restored central control system 200. In addition, the process register module 208 creates a register of the restore process. Said register, in a preferred embodiment, comprises success or failure of the restore process. Likewise, said register is sent to the cloud via the TCP/IP communications module 202 in order to show the state of the restore process.
- Data synchronization process, in which the central control system 200 has one time set to synchronize the data. The time set to perform data synchronization is checked, if the time is correct, whether there is a connection to the cloud is checked. If there is a connection to the cloud, the local database 205 is queried, the data stored in the local database 205 including the null synchronization date is filtered, and the data including null synchronization date with a pending synchronization status is identified. Subsequently, a file is created with the previously identified data, wherein said file contains instructions to inform the cloud about the type of synchronization process: data entry to the cloud or update of the data in the cloud. Once the file with the identified data has been created, it will be sent through the TCP/IP communications module 202 to the cloud. In case the cloud receives the file with the data identified, the cloud will send a receipt acknowledge, wherein once the receipt of the file with the identified data is acknowledged, a date and time synchronization update of the identified data will be performed with a pending synchronization status. In addition, the process register module 208 creates a register of the data synchronization process. Said register, in a preferred embodiment, comprises success or error of the data synchronization process.
- Framework updating process, in which, upon receiving a Framework updating request from the cloud, said process is initialized.

First, the current Framework version that is located in the central control system 200 is verified and compared with a version proposed by the Framework updating request; in case of being different, the version of programs that will be updated will be requested through the web services module 206. The programs to be updated are related to the local database 205, to the local services and to internal processes of the central control system 200. Once the update is performed, the central control system 200 will be reset to restore the services and whether they are executed correctly will be verified. In addition, the process register module 208 creates a register of the Framework updating process. Said register, in a preferred embodiment, comprises success orfailure of the Framework updating process.
- Service restart process, which is initialized via the remote user interface 500 when sending a service restart request. The request is received via the messaging services module 207. Upon receipt of the request, all services of the central control system 200 are restarted and the event of the service restart process is registered in a local database 205. In case of cloud connectivity, said event is sent to the cloud via the TCP/IP communications module 202.
- Process for initiating services from the central control system 200, which consists of running a file that is run by the processor 203 of the central control system 200 to start the services to be run in the background. Said processes correspond to the communication of the central communications module 201 and the communication modules 104 of the intelligent switch devices 100, to the messaging services module 207, data backup process, data synchronization process and restoration process.
- Service verification process, in which, by means of the TCP/IP communications module 202 if there is connectivity to the cloud, in case the cloud returns confirmation of connectivity, the central control system 200 updates parameters in the cloud. In case the cloud does not return connectivity confirmation, the central control system 200 updates parameters in the local database 205.

Referring to the processes for the operation of the central control system 200, in case of no access to the cloud, the central control system 200 operates in local mode and disables the functions that need access to the cloud of certain processes.

Now, the processor 203 is also configured to send services and commands to the intelligent switch devices 100, which are:
- Process for sending firmware and/or bootloader program to intelligent switch devices 100. In said process there are two cases of firmware and/or bootloader program update:
   when the user, via the remote user interface 500, creates an smart switch device 100 for the first time in the communication network and when there is a firmware and/or bootloader program version update. In either of the two update cases, the central control system 200 sends the file corresponding to the smart switch device 100.

Additionally, in another preferred embodiment, the central control system 200 can learn patterns and behavioral habits of the user through machine learning processes, to adapt their operation depending on said patterns. For example, an "out-of-home" mode may be activated, wherein the central control system 200 may activate lighting devices based on the patterns and behavioral habits of the user while away from home. In a secondary embodiment, the user may also program his/her own routines for turning on and off lighting devices, in order to simulate the presence of persons in the house.

In yet another embodiment, the user may be notified via the remote user interface 500 when the user interface 103 of an smart switch device 100 is activated when the latter is in the "out-of-home" mode.

Within the present invention, two types of firmware are considered, basic and advanced. The basic firmware allows basic functionality such as the manual activation of any of the electrical connection lines 105 of the intelligent switch devices 100 via the user interface 103, for example, in an embodiment where three lighting devices are connected to the three paths 105 any of said three paths 105 can be activated independently by means of the user interface 103; and having communication with the central control system 200 to be able to upgrade the basic firmware to the advanced firmware. On the other hand, the advanced firmware allows basic firmware functionality, in addition to mapping the user interface 103, locking the user interface 103, a sleep mode, activating or deactivating the buzzers or speakers of the user interface 103, and the activation of any of the electrical connection lines 105; all of these functionalities performed by a remote user interface 500. In a preferred embodiment, the remote user interface 500 may be, for example, an application of a mobile user equipment, a web page, or wearable devices such as wearable devices sold under the brands Apple Watch or Samsung Gear, among others.
- Process for sending factory reset to the intelligent switch devices 100. In said process, from the remote user interface 500, the smart switch device 100 to which the factory reset will be sent is selected. The central control system 200 receives, by means of the messaging services module 207, the factory reset command together with the ID of the smart switch device 100; the central control system 200, via the central communications module 201, sends the factory reset command to the smart switch device 100.
- Process for sending specific commands to the intelligent switch devices 100. In said process, the smart switch device 100 to which a specific command will be sent is selected from the remote user interface 500. The central control system 200 receives, by means of the messaging services module 207, the specific command together with the ID of the smart switch device 100; the central control system 200, via the central communications module 201, sends the specific command to the smart switch device 100. The smart switch device 100 sends back confirmation of its current state and the execution of the command to the central control system 200.

In an additional embodiment, the services interact with said process register module 208, this component generates log files in case of exceptions. Log files are sent by the cloud if they exist. In a preferred embodiment, a log file is generated per day, and preferably the database data generated on that day is sent daily to an external server via the TCP/IP communications module 202. The log files remain a predetermined period of time in the central control system 200, after this period elapses, the files are automatically deleted.

In a preferred embodiment of the present invention, the central control system 200 performs the functions that are in charge of managing the errors that are presented by validating them, displaying them, storing them in log files or in database. When an attempt is made to store a database error and it is not available then the error is stored inside a log file.

In a preferred embodiment, the messaging services module 207 uses a communication process trough the MQTT protocol, so that interaction of the user equipment with the central control system 200 and the intelligent switch devices 100 is allowed.

The process initially defines the communication constants by making a query to the database; in a preferred embodiment the database 205 of the present invention refers to a local database.

The service is initialized by defining the url address of the MQTT server, the client ID, and the persistence type. The process initializes a method called "callback" and creates the instance of the connection to the MQTT server. If the connection is not successful, the corresponding exceptions are written to the logs, otherwise it is waiting for messages to be entered via the "callback" method.

When the arrival of a message is detected it evaluates it and if it meets the established criteria, the process of sending data to the communications module 104 for the corresponding intelligent switching device 100 is started. In case of exceptions, it is written in the registers of the central control system 200.

The central communications module 201, in a preferred embodiment, performs the radio communication, and its features are similar to those of the communications module 104 of the intelligent switching device 100.

Importantly, the radius is configured, by the central control system 200, by writing configuration registries, by modifying the node, synchronization, frequency, mode of operation and power features.

In the present invention the central communications module 201 is responsible for communicating to each of the intelligent switch devices 100 with the central control system 200 as well as the communication between the other intelligent switching devices 100 to establish a mesh communication network, in a preferred embodiment using a network called "multi-point mesh PtP, PMP, Mesh" with routing tables and dynamic trajectories replicated at the central level.

In a preferred embodiment, the communications between the central control system 200 and the communication modules 104 of the intelligent switch devices 100 are encrypted. Similarly, the communication between the web services module 206 and the cloud is encrypted.

A further advantage of the present invention is the loading and updating of the firmware of the central control system 200 and the smart switch device 100 in a remote and controlled manner by means of a bootloader, this process performs the updating of both firmware in basic option or firmware in advanced option through wireless radio.

Significantly, the way the firmware update takes place has two initialization modes, one that only allows to update the firmware from the bootloader and another one that only initiates automatically the basic or advanced firmware. The initialization of the firmware load begins when the central control system 200 gives the command to the remote smart switch device 100 for its updating as long as the firmware version is correct, and the smart switch device 100 changes the bootloader initialization flag. In a secondary embodiment a reboot is performed and later the firmware will be loaded. After initialization, the data integrity check is performed in which the microcontroller verifies that each byte is valid in its memory comparing it with a first image and a second image; if not, notifies the central control system 200 that there is an error in the version, notifying the central control system 200 that the update can not be performed, changing the flag to normal operation mode, deleting the memory locations where the wrong firmware was housed. It immediately restarts to operate in basic or advanced mode while waiting for the transfer of new updates. In case the data is correct, it proceeds to the update.

Significantly, the firmware transfer is performed in two memory sectors to ensure that the transfer is correct. Once the firmware has been updated, one of the two sectors where the firmware was installed during the transfer is deleted from memory to free up space for future updates.

Other embodiments of the invention will be apparent to those skilled in the art from consideration of the specification and practice of the invention disclosed here. This application is intended to cover any variations, uses, or adaptations of the invention following the general principles thereof and including such departures from the present disclosure as come within known or customary practice in the art. It is intended that the specification and examples be considered as exemplary only, with a true scope and spirit of the invention being indicated by the following claims.

It will be appreciated that the present invention is not limited to the exact construction that has been described above and illustrated in the accompanying drawings, and that various modifications and changes can be made without departing from the scope thereof. It is intended that the scope of the invention should only be limited by the appended claims.

## Claims

1. A system comprising:
- a low power lighting load adapter (113) connected in parallel to a first lighting load (112a) of at least one lighting load (112a,112b,112c), wherein the first lighting load (112a) is a low power lighting load, the low power lighting load adapter (113) comprising resistive elements or capacitive elements or inductive elements, or a combination thereof, and having lower impedance than the first lighting load (112a); and
- a power supply (101a) powered by a mains electricity (111) for a two-wire or three-wire smart switch (100), connected to the at least one lighting load (112a,112b,112c), to control the power on and power off of the at least one lighting load (112a,112b,112c), the power supply (101a) comprising:
a first low power module (106) configured to receive an AC powerfrom the mains electricity (111) flowing through the first lighting load (112a) and the low power lighting load adapter (113) when the first lighting load (112a) is in its off state, to convert the AC power from the mains electricity (111) into a first level DC voltage and to output the first level DC voltage to a second low power module (107);
a second low power module (107) configured to convert the first level DC voltage from the first low power module (106) into a second level DC voltage when the first lighting load (112a) is in its off state, wherein the second low power module (107) is further configured to convert the first level DC voltage from a third low power module (108) into the second level DC voltage when the first lighting load (112a) is in its on state;
a third low power module (108) configured to receive a shunt current (116) and to output the first level DC voltage to the second low power module (107) when the first lighting load (112a) is in its on state;
a high power module (109) configured to turn on the at least one lighting load (112a,112b,112c), when a respective one of at least one activation signal (ACTRLY1, ACTRLY2, ACTRLY3) is received from an external controller module powered by the second low level DC voltage, and to output the shunt current (116) out of the high power module (109) when the at least one lighting load (112a,112b,112c) is in its on state; and
a current sensing module (110) powered by the second level DC voltage and configured to convert the shunt current (116) from the high power module (109) into a current-voltage signal outputted to the external controller module.

2. The system of claim 1, wherein the at least one lighting load (112a,112b,112c) is one lighting load or the at least one lighting load (112a,112b,112c) are two lighting loads or the at least one lighting load (112a,112b,112c) are three lighting loads.

3. The system of claim 1, wherein the at least one lighting load (112a,112b,112c) is a resistive lighting load, a CFL lighting load, an LED lighting load or a combination thereof.

4. A system comprising:
- a low power lighting load adapter (113) connected in parallel to a first lighting load (112a) of at least one lighting load (112a,112b,112c), wherein the first lighting load (112a) is a low power lighting load, the low power lighting load adapter (113) comprising resistive elements or capacitive elements or inductive elements, or a combination thereof, and having lower impedance than the first lighting load (112a); and
- a power supply (101b) powered by a mains electricity (111) for a two-wire or three-wire smart switch (100), connected to the at least one lighting load (112a,112b,112c), to control the power on and power off of the at least one lighting load (112a,112b,112c), the power supply (101b) comprising:
a low power module (123) configured to receive an AC power from the mains electricity (111) flowing through the first lighting load (112a) and the low power lighting load adapter (113) when the first lighting load (112a) is in its off state, and to convert the AC power from the mains electricity (111) into a low level DC voltage;
a high power module (109) configured to turn on the at least one lighting load (112a,112b,112c) for less than a half cycle of the mains electricity (111), when a respective one of at least one activation signal (ACTRLY1, ACTRLY2, ACTRLY3) is received from an external controller module powered by the low level DC voltage, and to output a shunt current (116) when the at least one lighting load (112a,112b,112c) is in its on state;
a current sensing module (125) powered by the second level DC voltage and configured to convert the shunt current (116) from the high power module (109) into a current-voltage signal outputted to the external controller module; and
a zero crossing detection module (126) configured to output a zero crossing signal to the external controller module when a wave of the AC mains voltage crosses zero volts, for the external controller module to synchronize the timing and delay of the activation signal with the phase of the mains electricity (111);
wherein the low power module (123), the high power module (109), the current sensing module (125) and the zero crossing detecting module (126) are galvanically isolated from the mains electricity (111).

5. The system of claim 4, wherein the at least one lighting load (112a,112b,112c) is one lighting load or the at least one lighting load (112a,112b,112c) are two lighting loads or the at least one lighting load (112a,112b,112c) are three lighting loads.

6. The system of claim 4, wherein the at least one lighting load (112a,112b,112c) is a resistive lighting load, a CFL lighting load, an LED lighting load or a combination thereof.
